(19) Europäisches Patentamt
European Patent Office
Office européen des brevets

(11) **EP 2 375 190 A1**

(12) **EUROPEAN PATENT APPLICATION**

(43) Date of publication:
**12.10.2011 Bulletin 2011/41**

(51) Int Cl.:
***F25B 21/04*** (2006.01)   ***H01L 35/32*** (2006.01)

(21) Application number: **11172236.9**

(22) Date of filing: **10.12.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **11.12.2008 IL 19590208**
**27.01.2009 IL 19675309**
**10.08.2009 IL 20031709**

(62) Document number(s) of the earlier application(s) in accordance with Art. 76 EPC:
**09804337.5 / 2 370 754**

(71) Applicant: **Lamos Inc.**
**1650 Beersel (BE)**

(72) Inventors:
• **Danenberg, Noam**
  **45204 Hod HaSharon (IL)**
• **Maron, David**
  **43229 Raanana (IL)**

(74) Representative: **Bongiovanni, Simone et al**
**Studio Torta S.r.l.**
**Via Viotti, 9**
**10121 Torino (IT)**

Remarks:
This application was filed on 30-06-2011 as a divisional application to the application mentioned under INID code 62.

(54) **Thermo-electric structures for cooling, heating, and electric current generation**

(57) A thermo-electric structure (100) for cooling, heating, or stabilizing the temperature of an object or for electric power generation, said thermo-electric structure comprised of:

a) at least one n-type leg (16N) and at least one p-type leg (16P), wherein each of said legs is comprised of a semiconductor element on the heat absorbing side of said thermo-electric structure, a semiconductor element of the same type on the heat dispersing side of said thermo-electric structure, and an intermediate connector that thermally and electrically connects said two semiconductor elements; and

b) at least one additional n-type semiconductor element (16N); and

c) at least one additional p-type semiconductor element (16P);

said thermo-electric structure characterized in that said additional semiconductor elements act as point absorbers of heat from interior thermo-electric junctions and cause different values of electric current to flow through different parts of said structure.

Fig. 18

EP 2 375 190 A1

**Description**

**Field of the Invention**

The present invention relates to the field of thermo-electric technology. Specifically the invention relates to the design characteristics of thermo-electric systems for cooling, heating, and/or power generation.

**Background of the Invention**

Significant progress in thermo-electric energy conversion technology has been made by developing advanced thermo-electric materials having high values of Figure of Merit, denoted usually by Z, whereby:

$$Z = \alpha^2 k_e / k_t \qquad\qquad \text{equation (1)}$$

where:

$\alpha$ = the thermo-electric Seebeck coefficient
$k_t$ = the total thermal conductivity;
$k_e$ = the electrical conductivity.

In thermal-electric devices the conversion efficiencies depend on the specific materials and the temperature differences involved. However with presently available thermo-electric modules, as the temperature gradient between the hot and cold sides increases, the thermo-electric material does not necessarily work at its optimal temperature, i.e., where the figure of merit is at its maximum. This is due to the very short thermo-electric legs, i.e. to the short length of the p,n pellets (sometimes 1-2 mm.), used which results in the hot zone and the cold zone being in close vicinity to each other. As a result the single layer thermo-electric leg must be able to function over a wide range of temperatures.
The geometry of the thermo-electric structure combined with the physical properties of the materials determine the overall performance of the thermo-electric module. For thermo-electric generation the relations of these parameters to the module power are well-known in the literature and can be expressed as:

$$P = \frac{\alpha^2 NA*(T_h - Tc)^2}{2r(L + r/r_c)(1 + 2(\lambda/\lambda_c)(Lc/L))^2} \qquad\qquad \text{equation (2)}$$

Where:

$P$     is the module power
$N$     is the number of elements
$T_n$    is the module hot side temperature
$L$     is the element length
$r$     is the electrical resistivity ($1/k_e$)
$\lambda$     is the thermal resistivity of the module ($1/k_t$)
$\alpha$     is the Seebeck coefficient
$A$     is the area of elements
$T_c$    is the module cold side temperature
$L_c$    is the thickness of the insulating ceramic
$r_c$    is the contact electrical resistivity.
$\lambda_c$   is the contact thermal resistivity.

Considering equation (2) and ignoring the interfacial resistances at the various contact faces, the expression for the power can be simplified to:

$$P = \frac{\alpha^2 NA(\Delta T)^2}{2rL} \qquad\qquad \text{equation (3)}$$

In view of equations (2) and (3) reducing the separation distances, L, between the hot and cold junctions, on the one hand may enhance the power generation. On the other hand, the effects of thermal diffusion due to the increased temperature gradient, $\Delta T/\Delta L$, as well as the performance of the same thermo-electric material over the large temperature range, may cause a significant deterioration of the overall performance of the thermo-electric module.

In co-pending International Patent Application PCT/ IL2009/000666 by the same applicant, the description of which, including publications referenced therein, is incorporated herein by reference, various constraints, limitations and obstacles which are inherent to the standard thermo-electric modules are widely discussed.

The direction taken by the inventors in this PCT application has been to propose changes in the basic structure of the typical thermo-electric modules, which in fact address most of the limitations and disadvantageous constraints of the existing standard thermo-electric modules.

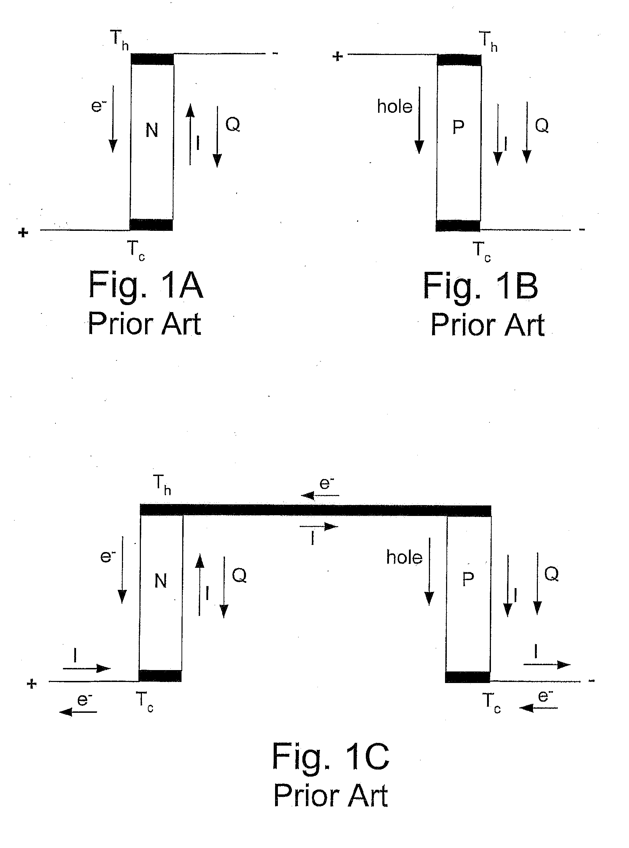

Fig. 1A and Fig. 1B illustrate the directions of flow of electric current, heat, electrons, and holes through n-type and p-type pellets respectively. If an electric voltage is maintained across the ends of the pellets, then, according to the Peltier Effect a heat gradient will be established and heat will be transferred from the side labeled $T_h$ to the side labeled $T_c$. Alternatively, if a heat gradient is maintained between the hot and cold sides, then the Seebeck effect occurs, i.e. a current will flow through the pellets in the direction indicated. Note that the heat flux flows in the direction of flow of the charge carriers, which is the direction of current flow in p-type semiconductor pellets but opposite to the direction of current flow in n-type pellets.

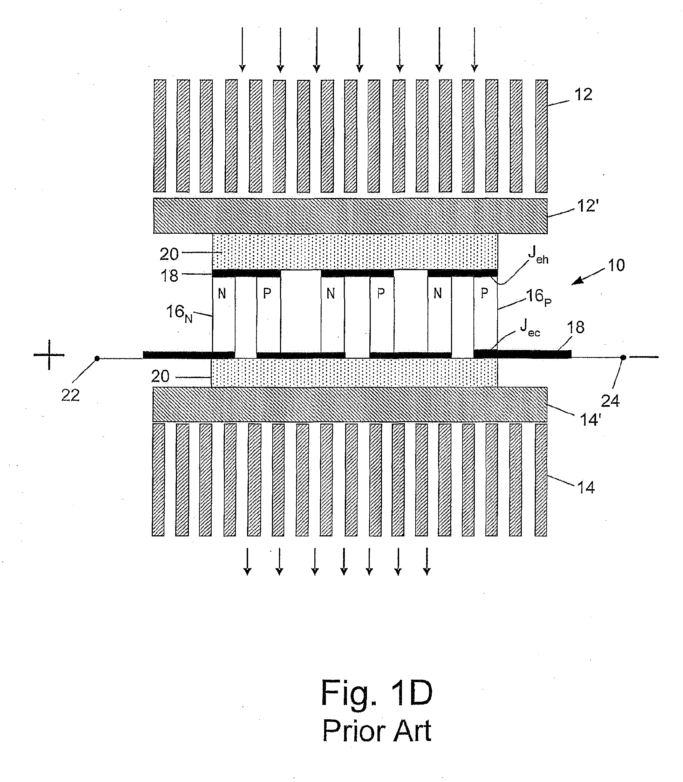

A p-n semiconductor pair is shown in Fig. 1C. The two pellets shown respectively in Fig. 1A and 1B have been connected in series electrically and as a result are connected thermally in parallel. A practical prior art thermo-electric device is comprised of a module that is typically comprised of 254-299 or more n-p pellets such as shown in Fig. 1D connected together electrically in series and supported by metalized ceramic plates. Depending on the application, two or more modules can function together to increase the amount of heat transferred or the electric power produced.

For the purpose of illustration, Fig. 1D symbolically shows a portion of a typical prior art thermo-electric module 10 sandwiched between an intermediate substrate 12' in thermal contact with heat source 12 and intermediate substrate 14' in thermal contact with heat sink 14. Module 10 is comprised of pairs of P type and N type semiconductor elements $16_P$ and $16_N$ electrically connected in series, by means of metallic conductor tabs 18. The external electric connections to the positive and negative poles of a DC power source are symbolically shown by connections 22 and 24 respectively. The semiconductor elements are thermally connected in parallel. To hold the pellets in place and stabilize the structure, the tops and bottoms of the semi-conductor elements $16_P$ and $16_N$ are pressed between ceramic plates 20. In the figure the arrows indicate the direction of heat flow.

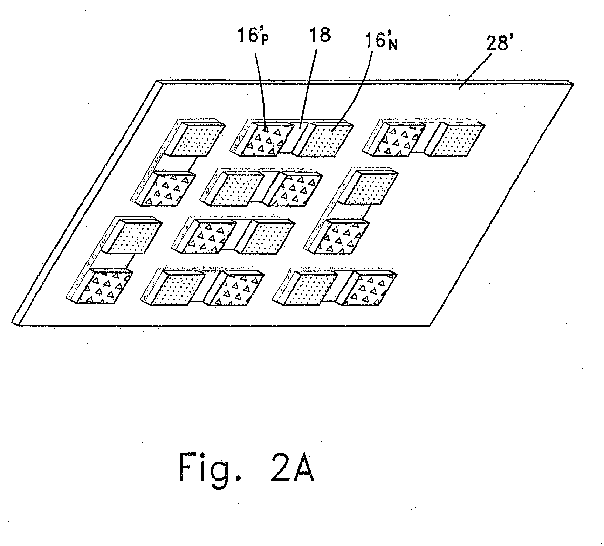

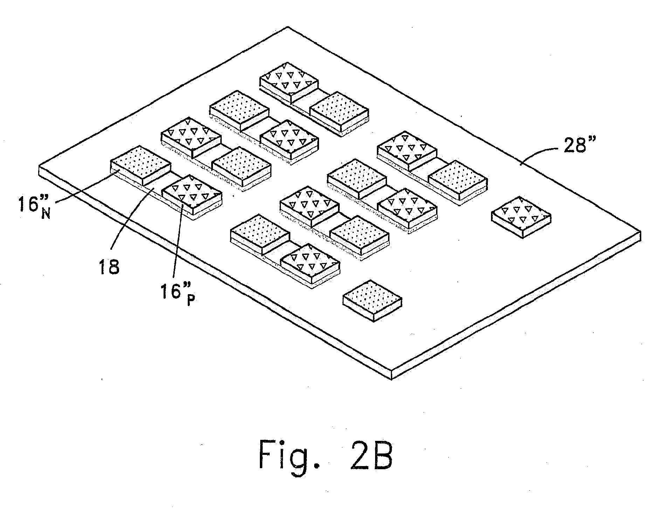

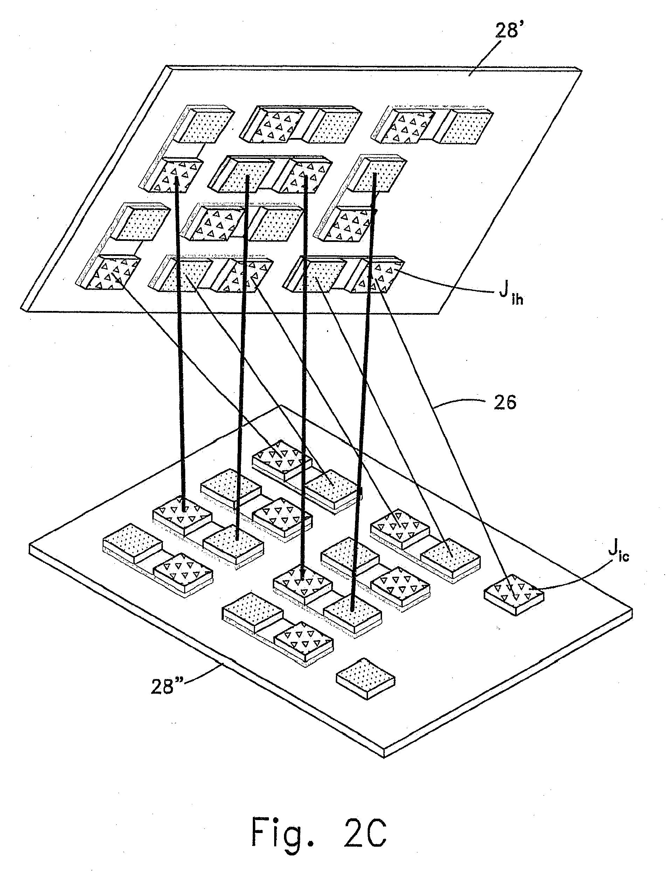

The characterizing feature of the thermo-electric structures proposed by the inventors in the above-referenced PCT Application is the use of a split-structure, whereby the p,n elements are each split into two or more pellets that are electrically and thermally connected by intermediate connectors. The split structure is schematically illustrated in Figs. 2A to 2C. Basically the p,n elements are each split into two pellets $16'_{P,N}$ and $16''_{P,N}$ that are electrically and thermally connected by intermediate connections 26. Fig. 2A schematically shows the heat dispersion side of the split module, which comprises support layer 28' to which are attached pairs of p,n pellets $16'_{P,N}$. Fig. 2B schematically shows the heat absorption side of the split module, which comprises support layer 28" to which are attached pairs of p,n pellets $16''_{P,N}$. As in the prior art, the pairs of pellets $16'_P$ and $16'_N$ and $16''_P$ and $16''_N$ are connected by metallic conductor tabs 18 that are attached to, or as will be described herein below, embedded in the support layers. Fig. 2C schematically shows the entire split module, with the respective p,n pellets on the heat absorption and heat dissipation sides of the module connected by intermediate connectors 26. Note that in Fig. 2C only half of the intermediate connectors 26 are shown for clarity. In order to keep the required figure of merit Z, the multiple intermediate connections 26 between the p,n pellets $16'_{P,N}$ located on the side of the remote heat source 12 and the p,n pellets $16''_{P,N}$ located on the side of the remote heat sink 14 are made of high electrical and thermal conductivity materials.

Herein the following terms have the following meanings:

- The terms "layer" and "pellet" are used interchangeably herein to denote the p or n-type semiconductor material in a thermo-electric structure.
- A "leg" is a thermo-electric structure that connects thermally and electrically the heat absorbing and heat dispersing sides of a thermo-electric structure. A thermo-electric structure usually comprises a plurality of pairs of p and n type legs connected thermally in parallel and electrically in series. A simple leg is constructed from two pellets or thin layers of either p or n-type semiconductor material that are respectively deposited or attached to the heat absorbing and dispersing sides of the thermo-electric structure and an intermediate layer of conducting material that is inserted between each such pair of pellets/layers and used to electrically and thermally connect the pellets/layers of the pair. A more complex leg may have the structure of a thermo-electric chain consisting of one or more pellets/layers, e.g. n layers, interposed between the pellets/layers on each side of the structure and n-1 intermediate layers that connect each of said pellets/layers to the successive one.

- The terms "layer", "intermediate layer", "conducting layer", "connection layer", "connector" and "conductor" are used interchangeably herein to refer to the conducting material that connects pairs of semiconductor layers in a leg.

- The term "layer" is frequently used herein in a generic sense to refer to each of the components, i.e. the pellets and the connection layers in a leg of a thermo-electric structure.

- The terms "asymmetry" and "asymmetrical" are used herein to indicate that in a given thermo-electric structure according to the invention, the dimensions, types of material used, and thermal, electrical, and thermo-electric parameters of the material used in the layers at the heat absorbing and dispersing sides of the structure are not the same. Similarly the materials that comprise the thermo-electric and connection layers in different legs of the devise do not have the same properties. Thus, structures of the invention can have asymmetrical heat absorbing or heat dispersing sides and/or asymmetrical legs.

As a result of the split structure, the support layers 28', 28", do not necessarily have to be rigid and therefore, for example flexible support layers that are thermally coupled to heat source 12 and heat sink 14 respectively can replace the rigid ceramic plates of the prior art. Also according to the present invention heat source 12 and heat sink 14 do not have to be in actual physical contact with intermediate substrates 12' and 14', but, in preferred embodiments, are in direct thermal contact with the support layers or with the thermo-electric elements themselves. Support layers 28', 28" suitable for use with the invention can take many different forms, depending on the application. Generally the material from which they are made is non-brittle and flexible, deformable or easily shaped to match the contours of the heat source or sink or intermediate substrate with which they are in thermal contact. Herein the support layers 28', 28" will be referred to by the generic term "flexible support layers" to differentiate them from the stiff, brittle ceramic substrates that must be used in the prior art. Nonetheless, it is to be understood than that reference to "flexible support layers" in both the description and the claims is not intended to necessarily mean that the support layers are flexible, but also can refer to layers having other properties as described herein. Typical examples of embodiments of the support layers will be described herein below.

One of the results of this split structure is that the heat source and the heat sink can be located apart from one another without any limitation on the particular structure or orientation of either one. In some sense this makes the mechanisms of the heat transfer at the hot and cold side independent from one another and disengaged from the core of the thermo-electric module. Moreover, with the split structure, the thermo-electric material length, L, can be dramatically reduced, while the temperature gradient is successfully maintained.

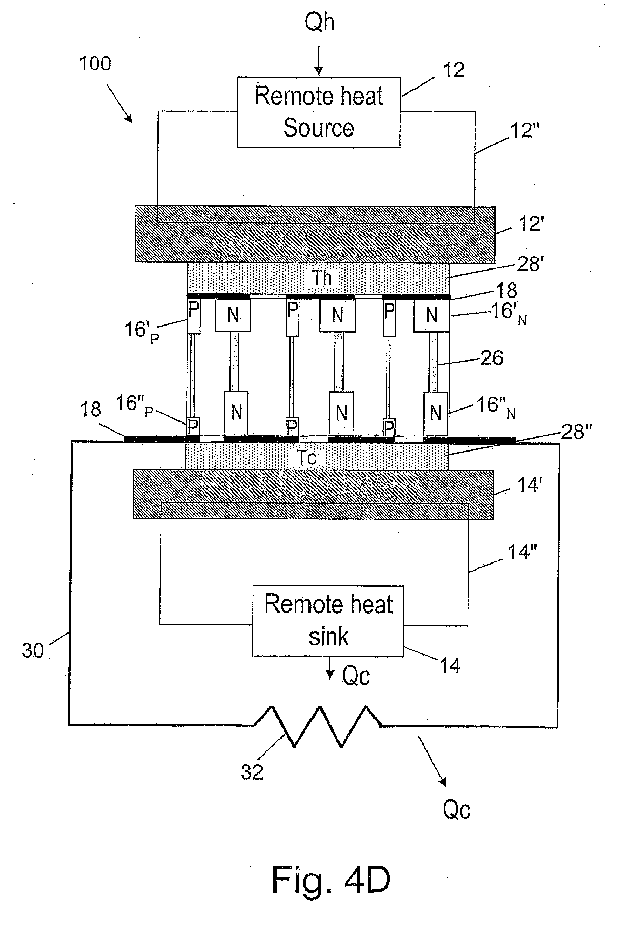

The characterizing features of the split thermo-electric structure described above are schematically illustrated in Fig. 4D. For clarity, Fig. 4D shows the basic embodiment in which the p,n elements are each split into two elements $16'_{P,N}$ and $16''_{P,N}$ that are electrically and thermally connected by intermediate connections 26. As in the prior art, pairs of elements $16'_P$ and $16'_N$ and $16''_P$ and $16''_N$ are connected by metallic conductor tabs 18 that are attached to the support layers 28', 28", which are in thermal contact with intermediate substrates 12' and 14', which are in turn thermally coupled to heat source 12 and heat sink 14 by thermal coupling means 12" and 14" respectively. As opposed to the prior art, according to the present invention heat source 12 and heat sink 14 do not have to be in actual physical contact with intermediate substrates 12' and 14'. In the figure the external electric circuit is symbolically shown as 30. For power generation circuit 30 comprises external load means symbolically shown by resistor 32. For heating and cooling applications resistor 32 is replaced by a DC power source.

Note that the requirement of extremely flat surfaces and uniform contact between the p,n elements and the stiff ceramic plates in the conventional modules places a practical limit on the cross-section, A of the thermo-electric elements which has a limiting effect on the total module power (see equation (2). In the split-thermo-electric structure, these limitations are eliminated; therefore it becomes possible to reduce the height of the thermo-electric material at both the side of the heat source and the side of the heat sink to the minimum thickness desired. Moreover, the cross-sectional area of the pellets, A, can be increased. As a result the practical height and cross-sectional areas of the p,n pellets is determined according to the specific physical system and is not limited by the thermo-electric module configuration only. It is of high importance to note that the split structure enables use of pellets having different dimensions and also pellets made of different thermo-electric materials at the hot and cold sides. This is important, as mentioned earlier, since the properties and characteristics of the thermo-electric material are temperature-dependent and thus one can choose the material which will give the best results for the specific temperatures at the cold and hot zones in a particular application.

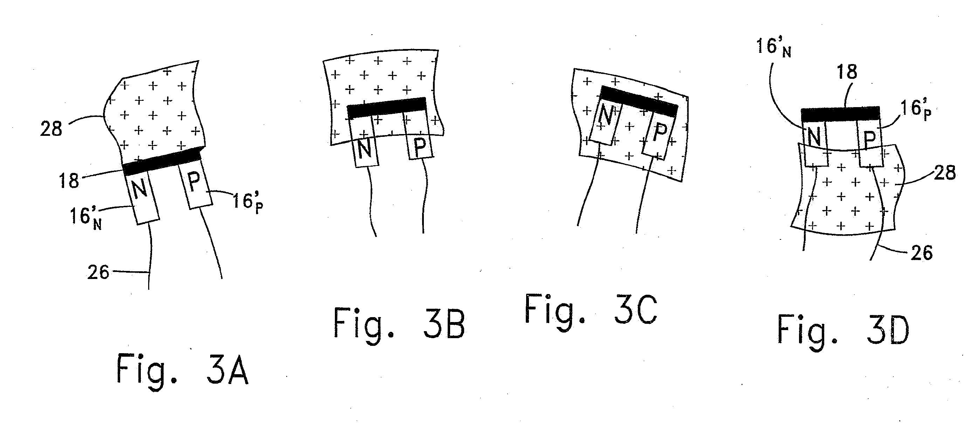

Thus, the concept of the split thermo-electric structure contributes to the reduction of the interfacial thermal resistance by eliminating the ceramic plates and instead utilizing an alternative thin flexible support layer, e.g. a conductive print material. The flexible support layer on the hot and cold sides need not be made of the same material. However, the material of the support layer must have the required physical property of non-electrical conductivity and resistance to high temperatures on the hot side. Fig. 3A to Fig. 3D schematically show a variety of ways that the p,n pellets can be integrated into the support layers. For illustrative purposes only the support layer on the high temperature side of the structure is shown. The pellets can be attached on the "inner" faces of the support layers (Fig. 3A), they can be partially (Fig. 3B) or totally (Fig. 3C) buried in the support layer, they can pass through and protrude from the outer faces of the support layer (Fig. 3D). In the latter configuration, the interfacial resistances and other thermal resistances present in the prior art conventional module are eliminated. The p,n pellets can be directly connected to the heat source or heat sink, according to a given application, and the heat flux is enhanced due to the direct contact heat transfer from the hot and cold regions to the thermo-electric material.

Additionally, by proper choice of material, the support layer may provide thermal insulation between the hot and cold zones (Fig. 3C and Fig. 3D), and thus prevent loss of heat and improve efficiency.

Eliminating the rigid ceramic plates is of importance not only in minimizing the interfacial thermal resistances and optimizing the overall associated heat transfer rates, but also enables the introduction of flexibility to the design of the thermo-electric modules. Problems of reduced reliability and security of the thermo-electric devices, caused by breakdown of the ceramic module due to cyclic thermo-stress can be very much reduced by using the flexible support structure of the invention.

Thus, as opposed to a traditional thermo-electric module with rigid ceramic plates that is practically limited to small area systems and limited plane geometries, the split structure with the features described herein above enables large scale systems to be designed and built. In view of equations (2) and (3) the power output is proportionate to both N, the number of the p,n elements and A, their cross-sectional area, since the elements are in principle combined electrically in series. However, for prior art modules, it is impractical to increase either N or A because of the essential requirements of ensuring an even pressure across the module surfaces, uniform flatness and other limitations associated with thermal stresses.

It is a purpose of the present invention to provide thermo-electric structures for heating, cooling, or stabilizing the temperature of an object or for electric power generation wherein the transport of electric energy between heat absorbing and heat dispersing side of the structure is disengaged from the flow of heat between the sides of the structure.

It is another purpose of the present invention to provide thermo-electric structures for heating, cooling, or stabilizing the temperature of an object or for electric power generation wherein the heat flux absorbed at the heat absorbing side of said object is split into two or more portions that are directed to different locations to be dispersed.

It is another purpose of the present invention to provide thermo-electric structures for cooling, heating, or stabilizing the temperature of an object or for electric power generation, wherein different values of electric current flow at the heat absorbing and the heat dispersing sides of said structure and through different elements in the interior of said structure.

Further purposes and advantages of this invention will appear as the description proceeds.

## Summary of the Invention

In a first aspect the invention is a split-thermo-electric structure for cooling, heating, or stabilizing the temperature of an object or for electric power generation. The structure of the invention is characterized in that the transport of the electric current between the heat absorbing and the heat dispersing sides of the structure is disengaged from the flow of heat between the sides of the thermo-electric structure.

In embodiments of the structure of the invention the heat absorbing and the heat dispersing sides of the structure are each comprised of a sandwich layer containing a plurality of n-type and p-type legs sandwiched between two support layers. The legs are connected electrically in series by means of metallic conducting tabs. The sandwich layers at the heat absorbing and heat dispersing sides are electrically connected by external electrical conductors to form a complete series electric circuit and are thermally connected by means of one or more heat transfer structures.

In embodiments of the structure of the invention the legs are comprised of single pellets of thermo-electric material. In other embodiments the legs are comprised of complex multilevel structures.

In embodiments of the structure of the invention there is no symmetry between the number, properties, geometry and any parameter of the structure of the legs in the sandwich layers at the heat absorbing and the heat dispersing sides of the structure. The support layer can be comprised of either a thin copper plate or copper foil that is coated with a layer of non-electrical conducting material or of a conventional PCB. In the latter embodiments a pattern of metallic conducting tabs is created on the surface of the support layer and the thermo-electric legs are connected to the conducting tabs.

The heat transfer structures of the structure of the invention can be either heat pipes, conduction carriers, or both. The number of heat transfer structures in the structure of the invention does not have to be equal to the number of legs in one or both of the sandwich layers.

In a second aspect the invention is a split-thermo-electric structure for cooling, heating, or stabilizing the temperature of an object or for electric power generation. The structure is comprised of one or more layers of thermo-electric material on the heat absorbing side of the structure. Each of these layers is connected by a connection layer to two or more layers of thermo-electric material on the heat dispersing side of the structure. The object can be a printed circuit, an individual chip, or processor to which the one or more layers of thermo-electric material on the heat absorbing side is attached directly.

The layer of thermo-electric material on either the heat absorbing side or the heat dispersing side or the layers on both sides of the structure can be sandwich layers that comprise a plurality of n-type and p-type legs sandwiched between two support layers. The legs are connected electrically in series by means of metallic conducting tabs. The layer at the heat absorbing side and the layers at the heat dispersing side are electrically connected by external electric conductors to form a complete series electric circuit and they are thermally connected by means of one or more heat transfer structures.

In a third aspect the invention is a split-thermo-electric structure for cooling, heating, or stabilizing the temperature of an object or for electric power generation. The elements of which the structure is comprised are arranged to cause different values of electric current to flow at the heat absorbing and the heat dispersing sides of the structure and through different elements in the interior of the structure. To cause different values of electric current to flow through different parts of the structure additional p-type and/or n-type thermo-electric elements can be introduced into the thermo-electric structure to serve as point absorbers of heat from the interior thermo-electric junctions.

All the above and other characteristics and advantages of the invention will be further understood through the following illustrative and non-limitative description of preferred embodiments thereof, with reference to the appended drawings.

**Brief Description of the Drawings**

- Fig. 1A and Fig. 1B illustrate the directions of flow of electric current, heat, electrons, and holes through n-type and p-type pellets respectively;
- Fig. 1C shows a n-p semiconductor pair;
- Fig. 1D symbolically shows a portion of a typical prior art thermo-electric module sandwiched between an intermediate substrate in thermal contact with a heat source and intermediate substrate in thermal contact with a heat sink;
- Fig. 2A schematically shows the electrical connection on the heat dispersion side of the split module;
- Fig. 2B schematically shows the electrical connection on the heat absorption side of the split module;
- Fig. 2C schematically shows the entire split module, with the respective p,n pellets on the heat absorption and heat dissipation sides of the module connected by intermediate connectors;
- Figs. 3A to Fig. 3D schematically show a variety of ways that the p,n pellets can be integrated into a flexible support layer;
- Fig. 4A, Fig. 4B, and Fig. 4C show the variation of the figure of merit Z with temperature T for various commercially available thermo-electric materials;
- Fig. 4D schematically illustrates the characterizing features of split thermo-electric structures;
- Fig. 4E schematically illustrates an embodiment of a split thermo-electric structure in which additional pairs of p,n elements have been added by electrically connecting them in series to the pairs of elements on the heat dispersing side of the core of the thermo-electric structure shown in Fig. 4D;
- Fig. 5 schematically shows an illustrative example of a thermo-electric n,p junction, wherein the thermo-electric materials are selected to give the optimal performance according to the principles of the present invention;
- Fig. 6 shows schematically an illustrative multi-layer split structure composed of successive thermo-electric materials;
- Fig. 7 graphically shows both the figures of merit for three different thermo-electric materials as a function of temperature and the temperature as a function of distance between the hot and cold sides as obtained using the heat transfer model;
- Fig. 8 schematically shows a design of a solar thermo-electric panel, which is the heat absorption side of a split thermo-electric structure according to the present invention;
- Fig. 9 schematically shows a prior art thermo-electric module modified by using p and n type legs comprised of two successive layers of thermo-electric material with a connection layer between them according to the present invention;
- Figs. 10A to 10C schematically show embodiments of thermo-electric chains that act as legs of a split thermo-electric structure;
- Fig. 11A illustrates the Peltier effect in a n-type element of thermo-electric material;
- Fig. 11B illustrates the Peltier effect in a split thermo-electric chain of the type shown in Fig. 10B;
- Fig. 12 is a set of graphs showing the temperatures at the interfaces between the elements of the thermo-electric chains of example 1;
- Fig. 13 is a set of graphs showing the temperatures at the interfaces between the elements of the thermo-electric chains of example 2;
- Fig. 14 schematically shows the basic scheme for one-type one-leg thermo-electric circuits for cooling;
- Fig. 15 schematically shows the basic scheme for one-type one-leg thermo-electric circuits for power generation;
- Fig. 16A and Fig. 16B illustrate two ways of constructing single-type thermo-electric modules that have been considered in the prior art;
- Fig. 17A and Fig. 17B show schematically series or parallel one-type thermo-electric circuits respectively;
- Fig. 18 schematically shows the basic thermo-split structure;
- Fig. 19 schematically shows an example of a support layer;
- Fig. 20 schematically shows the basic power-split structure;
- Fig. 21A shows the simple split structure;
- Fig. 21B shows the temperature profile at the various junctions shown in Fig. 21A;
- Fig. 22A and Fig. 22B schematically show two variations of current-split in a simple thermo-electric structure;
- Fig. 23A and Fig. 23B symbolically show a complete thermo-electric unit based on the current split structures of Fig. 22A and Fig. 22B respectively;
- Fig. 24 and Fig. 25 symbolically show alternative ways of routing the current through thermo-electric structures; and
- Fig. 26 and Fig. 27 show symbolically thermo-electric units that employ both the thermo-split and the current-split concepts.

## Detailed Description of Embodiments of the Invention

Herein the phrases "heat absorbing side", "hot side", "heat source" and similar terms are used interchangeably to designate the high temperature side of a thermo-electric structure. There are two main types of thermo-electric structure. The first is for cooling and heating. In these structures the high temperature side is where heat is removed from the structure. The second is for energy generation and the high temperature side is where heat is absorbed by the Seebeck effect. Herein the phrases "heat dispersing side", "cold side", "heat sink" and similar terms are used interchangeably to designate the cold temperature side of a thermo-electric structure that is used to generate electricity using the Seebeck Effect or the side of a thermo-electric structure to which heat is added by the Peltier effect.

As said herein above with reference to Figs. 2A to 2C, in order to keep the required figure of merit Z, the multiple intermediate connections 26 between the p,n pellets $16'_{P,N}$ located on the side of the remote heat source 12 and the p, n pellets $16''_{P,N}$ located on the side of the remote heat sink 14 are made of high electrical and thermal conductivity materials. The inventors of the present invention have investigated the properties of thermo-electric materials. New ways of selecting the thermo-electric materials to be used at different locations in the thermo-electric structure and new configurations for the intermediate connections that are the results of this work, which will enable the resulting thermo-electric structure to exhibit improved heating, cooling, and electric power generation characteristics, are now described.

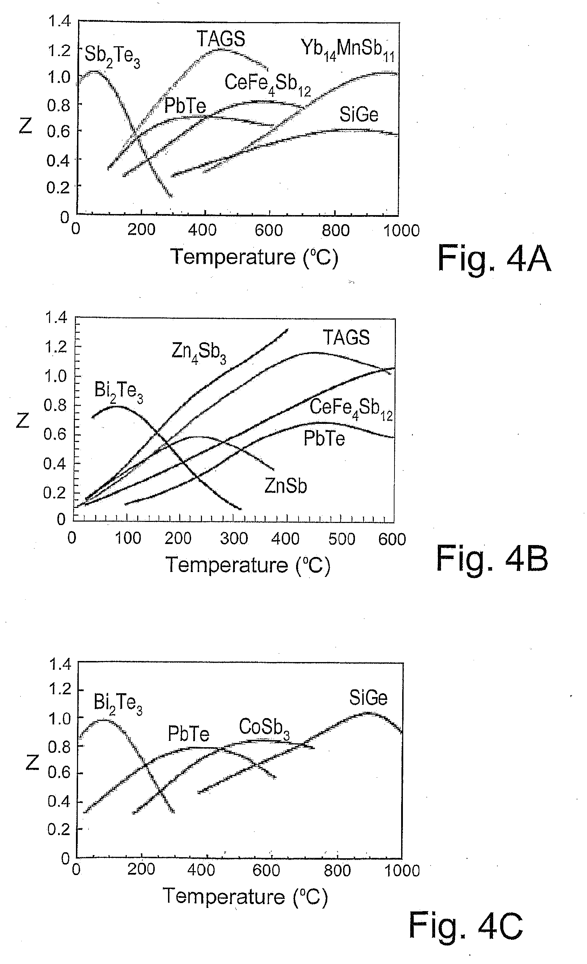

In order to introduce the concept of differentiation of the thermo-electric materials between the hot and cold temperature zones, which is essential to the optimal application of the split concept, the variation of the figure of merit Z with temperature T for various commercially available thermo-electric materials is shown in Fig. 4A, Fig. 4B, and Fig. 4C. From Figs. 4A to 4C, it is seen that for each thermo-electric material there is a temperature range where the thermo-electric performance is optimal.

Obviously, if only one type of material is utilized in a given thermo-electric leg, then the broader the overall AT on the thermo-electric module, the less efficient is the overall operation of the thermo-electric material. This decrease in efficiency will be especially felt in power generation systems where the temperature difference between hot and cold sides is normally on the order of several hundreds of degrees. The inclusion of two thermo-electric materials, for instance; one of which has its maximum Z corresponding to the temperature of the hot zone and the other having its maximum Z corresponding to the temperature of the cold zone, will enhance the thermo-electric efficiency at each zone, and hence improve the overall operation of the entire module system.

As noted earlier, the n,p thermo-electric pellets on the hot and cold sides are connected by intermediate connectors whose purpose it is to conduct both the electric current and the thermal flux with the best efficiency. However, whereas in standard non-split thermo-electric modules there are only two "external" thermo-electric junctions for each pellet (indicated by $J_{eh}$, $J_{ec}$ in Fig. 1D), on the hot and cold sides, in the split structure there are additional "interior" thermo-electric junctions at the interfaces between the split thermo-electric materials on the hot and cold sides and the intermediate connectors. These are indicated by $J_{ih}$ and $J_{ic}$ in Fig. 2C. It can be shown that thermo-electric Peltier effects occur at the interior junctions, which are the opposite of those that occur at the "exterior" junctions. Therefore, it is of high importance to control the thermo-electric effects at the "interior" junctions according to the given physical system and application, i.e. cooling, heating, or power generation.

Regular metallic conductors, although providing high thermal and electrical conductivities, may reduce the overall thermo-electric performance, because of the internal resistance at the junctions formed where the metallic conductor is joined to the thermo-electric pellets. It is therefore proposed that intermediate connectors made of thermo-electric materials and/or p,n-type doped metals instead of pure metal be utilized in the p,n legs and which will therefore correspond, e.g. have a close Z value, to the specific thermo-electric materials of the p,n pellets on the hot and cold sides.

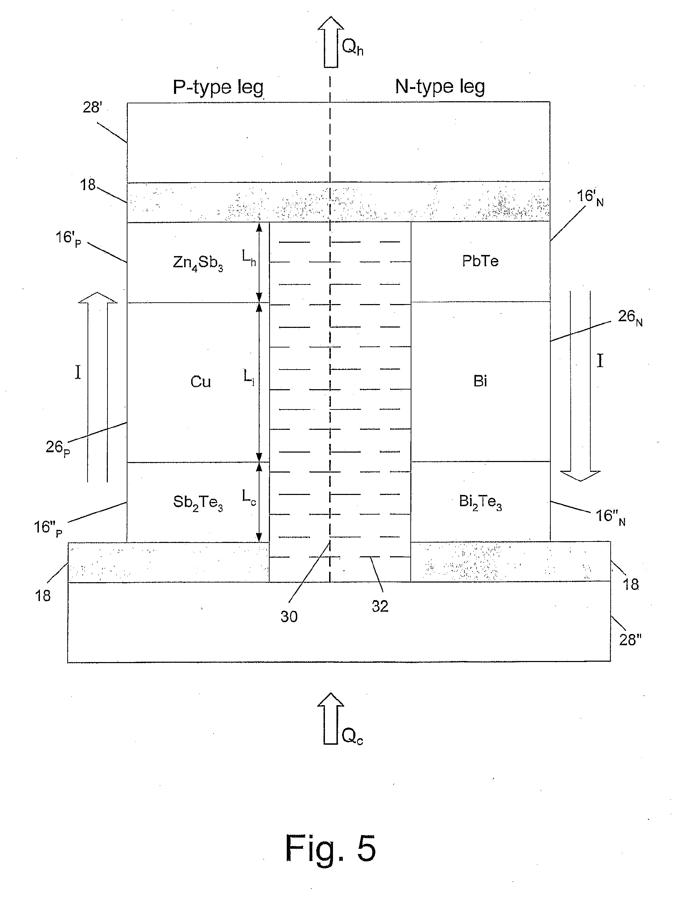

Fig. 5 schematically shows an illustrative example of a thermo-electric n,p junction based on the above described two principles: i.e. using different materials on the heat absorption and heat dispersion sides and using intermediate conductors made of different types of materials and having different dimensions, e.g. length L, in order to: 1) match the Z values of the materials to the temperature gradient between the hot and cold sides and 2) to reduce the effect of the internal connections. The junction is divided into p and n sides by imaginary center line 30 that bisects the structure. At the heat absorption side the p pellets $16_p"$ and n pellets $16_n"$ are each in thermal contact with conducting tabs 18, which are in thermal contact with a support layer 28" of material having a large specific heat coefficient $C_h"$. At the heat dispersion side the p pellets $16_p'$- and n pellets $16_n'$ are each in thermal contact with conducting tabs 18, which are in thermal contact with a support layer 28' of material having a large specific heat coefficient $C_{h'}$. The layers comprised of the p and n pellets are electrically joined in pairs or connected to an external electric circuit by conducting tabs 18, which can be comprised of copper, as is usual in the art, but may be advantageously comprised of other types of electrically conducting material. The space between and around the two sides is filled with a good thermal and electrical insulating material, e.g. silicon-based epoxy. The double arrows show the direction of electron flow through the junction.

The thermo-electric materials shown in the example of Fig. 5 are selected to give the optimal performance for $T_h$ = 300°C - 400°C and $T_c$ = 50°C - 60°C. As stated earlier for each side, for instance at the p-side, a hot p-type thermo-electric material, Zinc-Antimony $Zn_4Sb_3$ which has the highest values of Z of any of the materials shown in Fig. 4A at around 350°C has been chosen to be coupled with a cold p-type thermo-electric material Antimony-Tellurium, $Sb_2Te_3$, which has its maximum value of Z at around 50°C. On the n-side, a hot n-type thermo-electric material, Lead-Tellurium PbTe, $Z_{max} \sim$ 350°C and cold n-type thermo-electric material, Bismuth-Tellurium $Bi_2Te_3$, $Z_{max} \sim$ 60°C, are used respectively on the hot and cold sides. On the p-side a p-doped copper conductor has been chosen for the intermediate connector layer $26_p$. On the n-side, a pure bismuth conductor has been chosen for the intermediate connector layer $26_n$.

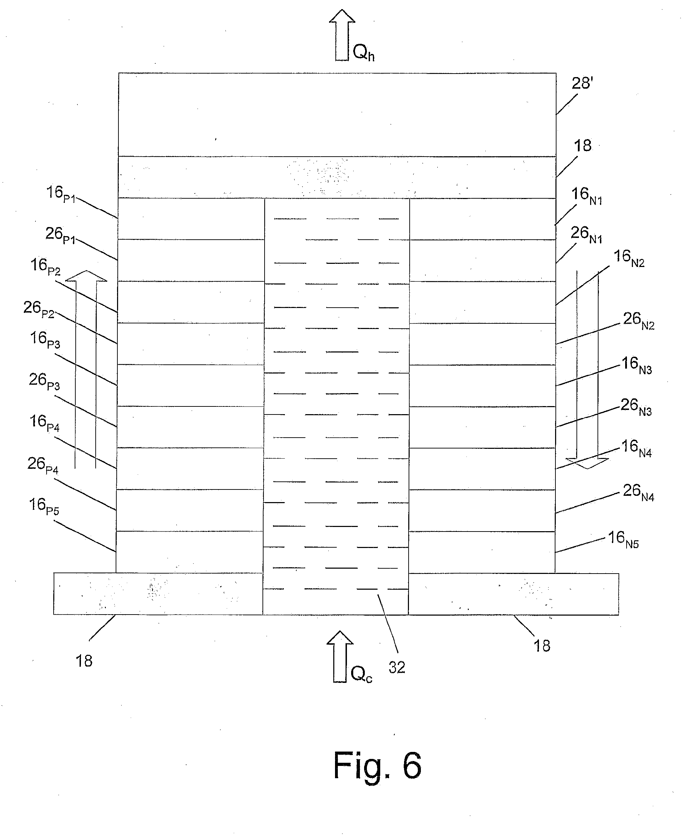

Fig. 5 illustrates the concept of differentiation of the thermo-electric material between the hot and cold sides and also between the p- and n-sides, for the case of two split thermo-electric layers connected by appropriately selected intermediate connectors. The same principles as presented with reference to Fig. 5 can be easily applied to three, four or more thermo-electric layers connected successively by appropriate conductive p-type or n-type intermediate connectors. If the materials are properly selected, such an arrangement will result in a much closer match of the Z value of the material to the temperature gradient and therefore will result in more efficient heat transfer or production of electric energy than conventional thermo-electric modules or even much simpler split-thermo-electric structures. An illustrative multi-layer split structure composed of successive thermo-electric materials is shown schematically in Fig. 6. The final design of the configuration of multiple successive layers shown in Fig. 6 is determined by requiring close coupling between the temperature distribution along the composite thermo-electric leg and the successive optimal figures of merit for various thermo-electric materials. The same principle as illustrated above with reference to Fig. 5 is used to select the materials used for the successive p-type layers and the intermediate p-type connectors that connect them and to select the materials used for the successive n-type layers and the intermediate n-type connectors that connect them. It is noted that to obtain optimal results, each of the materials selected differs from the others. Additionally, each of the layers can haves different physical parameters, e.g. cross-sectional area, length, or three-dimensional shape. In particular some or all of the connector layers can be wires or thin foil in some structures and in other structures have more substantial cross-sectional areas, e.g. equal to that of the two layers of thermo-electric material that they join.

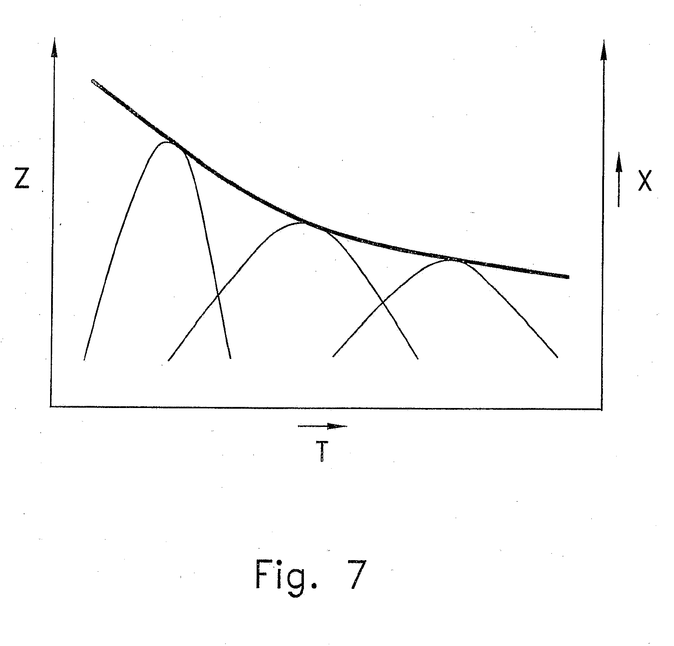

Fig. 7 schematically graphically shows both the figures of merit for three different thermo-electric materials (left vertical axis) as a function of temperature (horizontal axis) (lower three curves) and the temperature as a function of distance between the hot and cold sides (right vertical axis) (upper curve) as obtained using the heat transfer model for a thermo-electric leg similar to that shown in Fig. 5. Theoretically, it is required that in the ideal case the locus of the optimal values of the thermo-electric materials, $Z_{max}$, be matched as closely as possible with the temperature profile. Practically, however, the design of the thermo-electric structure must be in accordance with the available materials. In order to illustrate the process of designing such a structure an illustrative example will be presented herein below with regard to a specific application of a thermo-electric solar panel.

In one type of application of thermo-electric devices a heat source and a heat sink are available but are located apart from one another. Solar energy systems are typical of this type of situation. Utilizing the inexhaustible supply of solar energy is one of the most promising routes being followed in the search for developing techniques of renewable energy generation. Enormous efforts have been invested in developing efficient solar technologies of different types. The most basic form of solar technology is the use of solar panels that simply use the sun's energy to heat water or another fluid that flows through the panels. These are one of the most familiar uses of solar technology. Photovoltaic cells are so far the best known method and technology for generating electricity directly from sunlight. Solar photovoltaic panels are used in many applications. Photovoltaic cells so far developed have limited efficiency and the amount of electric energy which can be extracted from sunlight by photovoltaic methods is around 100-130 W/m2 (assuming a photovoltaic efficiency of 13-15%). Hence, a relatively large area of photovoltaic modules is required to generate large quantities of solar power. At the other extreme, large prototype solar energy plants of many types using dish, trough, and arrays of plane or concave mirrors have been designed and built to produce commercial quantities of electricity. These plants are expensive to build and maintain and typically require motors and control systems to move the mirrors for tracking the motion of the sun. The energy collected using these arrays is used directly in energy conversion devices, stored by various techniques, or is fed into the conventional electricity supply grid.

As opposed to the widespread use of photovoltaic cells that directly convert the sunlight into electricity, technologies based on thermo-electric modules are not yet widely used. The standard thermo-electric modules currently available are mainly used in cooling and heating systems and much less in electric power generation systems. In many applications thermo-electric devices are used only as auxiliary elements, for instance to collect and disperse waste heat or to cool photovoltaic modules.

Solar thermo-electric conversion relates to the practical application of the Seebeck effect, i.e. to the conversion of the temperature drop $\Delta T$ between one side of a thermo-electric module that is adapted to absorb solar energy and the other side of the thermo-electric module, which is in thermal contact with a heat sink, into electric power. The use of thermo-electric conversion systems is an emerging technology. In general, thermo-electric modules for power generation are relatively new and continuously undergoing improvement. However, at this stage in their development thermo-electric modules still have a typical efficiency of about 5% as compared with photovoltaic efficiency of about 15%. Thus, developmental efforts in thermo-electric conversion devices is concentrated on finding methods of solar energy collection and storage that are both relatively easy and low-cost in order to support and compensate for the present low efficiency of thermo-electric conversion.

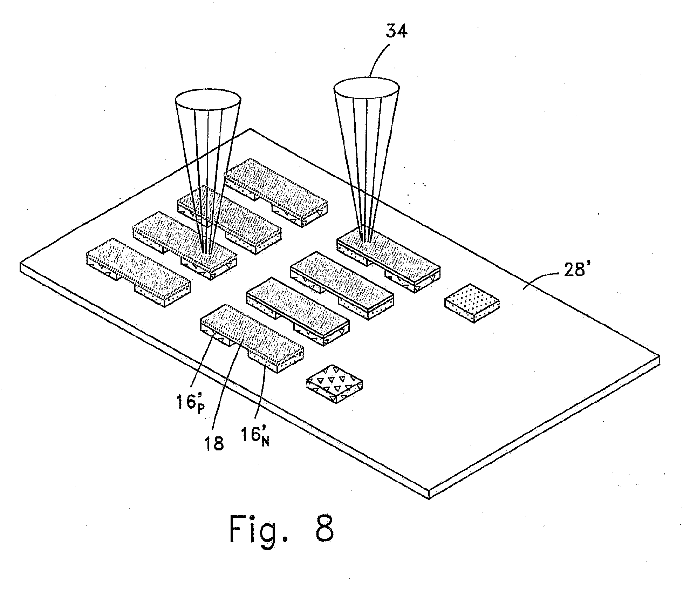

An advanced solar panel described herein below, which is based on the use of successive thermo-electric components as described herein above, provides the degrees of freedom necessary to optimize the overall thermo-electric effects by the choice of the appropriate thermo-electric material to use in the various temperature zones. Fig. 8 schematically shows a design of a solar thermo-electric panel, which is the heat absorption side of a split thermo-electric structure, as described herein above. The solar panel is built according to the embodiment shown in Fig. 3D and benefits from the advantages discussed herein above for this embodiment. The temperature difference for electric power generation results from concentrating sunlight directly on the p,n elements in the panel and connecting the hot side p,n elements to cold side p,n elements, which are in thermal contact with the surroundings, through thermo-electric intermediate connections composed of successive layers of materials. One of the main factors on which the amount of electricity that can be produced by this structure is dependent is the difference between the temperature resulting from the solar energy falling on the heat absorption zone and the ambient temperature of the heat sink zone.

Considering the structure shown in Fig. 8, the solar radiation impinging on the surface is clearly uniform (per unit total area). However, the effective thermo-electric area is only a fraction of the total area depending on the packing factor of the p,n pellets on layer 28'. In order to match the total incident solar radiation with the effective area of the thermo-electric material, convex lens assemblies 34 are used to condense and converge the radiation flux directly onto the p,n thermo-electric elements. As a result of the use of the lenses, the solar heat flux on the p,n elements is dramatically intensified resulting in high surface temperatures on the heat absorption side of the split structure. Since the n and p-type pellets are arranged in a series of pairs with a plated copper (or any other type of highly conductive) tabs connecting each p,n pair, resulting in good thermal connection between them, then practically it is only necessary to provide one lens to focus the sunlight on the conductor tab 18 of each pair. The value of the temperature on the hot side is determined by the flux of the solar radiation and the low temperature level is determined by the ambient temperature. Thus, the overall temperature gradient on the thermo-electric system is $(T_s - T_\infty)$, where $T_s$ is the temperature which is achieved by concentrating the solar flux on the hot side p,n elements and $T_\infty$ is the ambient temperature.

For a composite thermo-electric leg such as that shown in Fig. 5, which is exposed to a flux $Q_h$ at its upper surface, then the thermal flux $Q_h$ is obtained as stated previously, by concentrating the sunlight flux Qs impinging on the panel, where clearly, $Q_h \gg Qs$. For simplicity, assume that the heat convection at the exposed surfaces or the elements that comprise the p,n legs is negligible. Furthermore, for the purposes of demonstrating the principles involved only, no heat generation or local flux is included except the flux $Q_h$ of the focused solar radiation. Using these assumptions it can easily be shown that the temperature as a function of geometrical parameters and physical properties of the layers comprising each leg (see Fig. 5) are:

$$T_1 = T_h - Q_h\, L_h / A_h k_h \qquad\qquad \text{equation 4(a)}$$

$$T_2 = T_1 - Q_h \, L_i \, / \, A_i \, k_i \qquad\qquad \text{equation 4(b)}$$

$$T_c = T_2 - Q_h \, L_c \, / \, A_c \, k_c \qquad\qquad \text{equation (4c)}$$

$$T\propto = T_c - Q_h \, /\_A_c h_c \qquad\qquad \text{equation 4(d)}$$

where, $T_1$ is the temperature at the interface between $16'_{p,n}$ and $26_{p,n}$, $T_2$ is the temperature at the interface between $26_{p,n}$ and $16''_{p,n}$, A is the cross-sectional area of the thermo-electric element, L is the length of the element, k is the thermal conductivity of the element, sub h refers to the hot side, and sub c refers to the cold side, sub i refers to the intermediate connection layer and $h_c$ is the convection heat transfer coefficient on the cold side.

Alternatively, given the temperature gradient, the layer thickness for given values of intermediate temperatures can be derived from:

$$L_h = (T_h - T_1) \, A_h \, k_h \, / \, Q_h \qquad\qquad \text{equation 5(a)}$$

$$L_i = (T_1 - T_2) \, A_i \, k_i \, / \, Q_h \qquad\qquad \text{equation 5(b)}$$

$$L_c = (T_2 - T_c) \, A_c k_c \, / \, Q_h \qquad\qquad \text{equation 5(c)}$$

$$T_c = T_\propto + Q_h \, / \, A_h h_c \qquad\qquad \text{equation 5(d)}$$

In view of equations (4), the intermediate temperatures for a given set of physical properties and geometry of the thermo-electric leg are expressed in terms of the axial distances from the hot surface. Thus, when the thickness of each layer is known, the corresponding intermediate temperature is determined, and then the appropriate thermo-electric material, i.e. the thermo-electric material having the optimal figure of merit at the given temperature, can be selected. Alternatively, when specific thermo-electric materials are selected, the optimal temperatures corresponding to their figures of merit are known and the thicknesses of each of the layers can be estimated by using equations (5).

Note that the model from which equations (4) and (5) were derived relates to a specific physical system, i.e. that of Fig. 5. Clearly the successive figures of merit can be coupled with a heat transfer model that imposes different two or three dimensional boundary conditions. For example the model could include convection at the pellets or intermediately connections; heat generation, i.e. Joule heating at the boundaries; the Peltier effect at the junctions; elements having different cross-sectional areas A compared to other elements; elements that have different three dimensional shapes; etc. These boundary conditions can be used with any physical system which may comprise any set of temperature levels, according to the physical parameters of the application under consideration.

It is worth emphasizing that in the case of varying solar flux or varying temperature at the boundary surfaces, i.e. varying boundary conditions, the resulting temperature distribution will vary correspondingly. However, with the structure of successive thermo-electric materials that provides a differential figure of merit along the thermo-electric leg, an optimal thermo-electric layer can almost always be included, which will improve the overall performance of the structure when exceptions to the design conditions occur.

Moreover, the split structure and the concept of successive multi-layer thermo-electric materials enables a separate, comprehensive optimization of all geometrical parameters, physical properties of the various thermo-electric materials, and intermediate connectors, as well as the design of stratified thermo-electric layers at both the n-side and p-side. Such an optimization is impossible in the standard thermo-electric modules of the prior art.

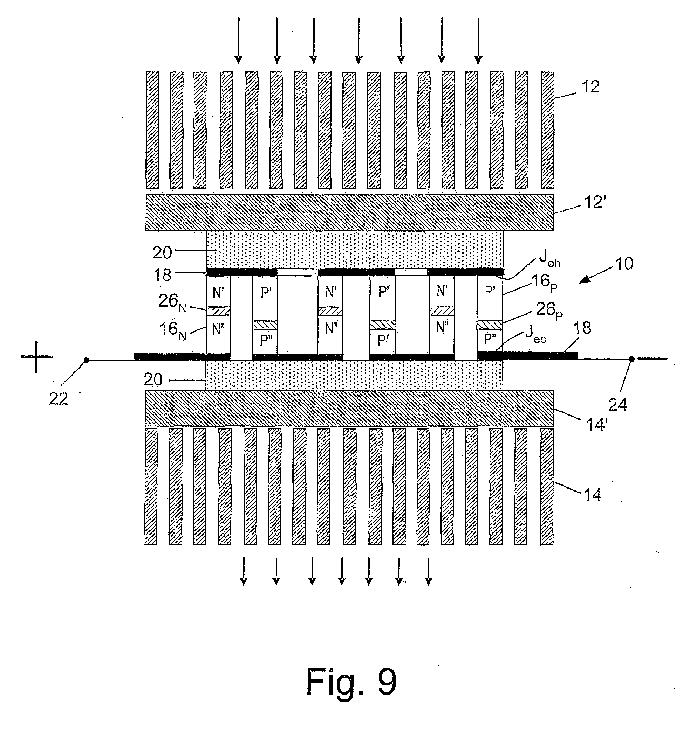

Having said this, however, it is emphasized that the concept of temperature successive thermo-electric materials can be applied in standard thermo-electric modules as well. Typical non-split thermo-electric modules are usually very thin (1.5 - 2 mm) and are subjected to wide ranges of temperature, sometimes of several hundred degrees. Therefore, their performance may be greatly improved if an appropriate set of successive thermo-electric materials are adopted to replace the single layer p,n pellets currently used. Fig. 9 schematically shows a prior art thermo-electric module modified according to this principle. Each of the p and n type legs are comprised of two successive layers of thermo-electric material with a connection layer between them according to the present invention. Assuming a hot side temperature of 300°C - 400°C and a cold side temperature of 50°C - 60°C, then, referring to Figs. 4A and 4B, a good choice of thermo-electric materials would be N'' = PbTe, N' = $Bi_2Te_3$, P'' = $Zn_4Sb_3$, P' = $Sb_2 Te_3$, $26_n$ = Bi, and $26_p$ = p-type copper. The connection layers can be made from a pure metal, alloys of metals, p-doped metal, n-doped metal, p-doped semiconductor material, or n-doped semiconductor material, wherein similar considerations to those described herein for selecting the thermo-electric material are employed to select the material most suitable for the connection layers in a given application.

The method of using a split structure and/or multi-successive layers enables the design and operation of thermo-electric, structures, modules, devices, and systems over wide ranges of temperature and also temperature gradients, while at the same time optimal performance can be ensured for each thermo-electric layer.

When a structure having legs comprised of multiple layers connected by intermediate connection layers, which are optimally matched to the pellet at both the hot and cold sides as is illustrated in Fig. 6 is provided, thermo-electric and resistance effects will occur at each junction between layers. However, by proper choice of material these effects can be made essentially negligible and even made to contribute to the overall heat transfer in the structure.

The multi layer structure may be accompanied by several effects which should be considered in designing a thermo-electric structure for a particular physical system. Some of these effects are:

- The amount of heat rejected or absorbed at each junction of the thermo-electric leg depends on the physical contact between the levels and the electron density of each of the materials comprising the interface. When the materials have large differences in their electrical density function, the amount of heat, that is absorbed or rejected, is large. Materials with similar electrical electron density reject or absorb heat only to a small extent. Taking this into account, the conducting layers between p-type and n-type materials having different electron densities in the legs of a structure should not necessarily be copper as is the conventional case. Preferably the material for the conducting layers should be chosen from amongst a wider range of conductors, e.g. copper, gold and nickel or their alloys or p-type or n-type doped metals, while taking into account the different electron densities of the materials forming the junction.

- The efficiency of a thermo-electric generator is defined by the ratio of the electrical power produced to the amount of heat absorbed by the module. Increasing the efficiency can be achieved by preventing any loss of thermal heat to the surroundings and by increasing the heat transferred through the thermo-electric material. One way to achieve this goal is to surround the legs with thermal and electric insulating material such as epoxy glue.
  In the case of cooling systems, the negative heat Peltier effect, i.e. heat absorption, at one junction may positively contribute to the performance of the unit while the positive Peltier effect, i.e. heat dissipation, may reduce the performance as a result of an additional heat flux load. In such a system, heat insulation should be used at the junction where negative heat development takes place. At the other junction heat dissipation can be enhanced by utilizing porous semiconductor pellets. It is to be noticed that porous medium can be utilized in any case that heat transfer enhancement is desired. For instance at a positive heat (dissipation) Peltier junction, at the intermediate conductors (26) in a cooling system, or even at the substrate at the hot and cold zones (18, 28', 28'' and 20).

- When two or more thermo-electric materials are joined in series they are constrained to transmit equal thermal and electric currents throughout the layers of the thermo-electric structure. However, each material efficiently converts heat into electricity only with a specific ratio between the thermal and the electrical conductivity. The thermal and the electrical conductivities are linked according to the Wiedemann-Franz Law:

$$K_t/K_e = Const * T(^\circ K) \qquad equation\ (6)$$

Where Kt is the thermal conductivity, $K_e$ is the electrical conductivity and T is the absolute temperature. When the layers of thermo-electric material have different ratios of thermal to electrical conductivities the efficiency of the thermo-electric unit is lowered. A measure for this ratio of thermal to electric conductivity of a layer is called "the consistency factor" (CF) of the material in the layer. The CF is a function of the Seebeck factor $\alpha$, the figure of merit, Z, and the absolute temperature T.

$$CF = (\sqrt{1-ZT} + 1) / \alpha T \qquad equation\ (7)$$

In the case of successive layers of thermo-electric materials, to keep the efficiency of the thermo-electric unit at maximum, the consistency factors between adjacent layers must have close values. As a rule of thumb, when the ratio between the consistency factors of adjacent layers is greater than two then the efficiency of the thermo-electric unit will be drastically lowered.

In order to design a good thermo-electric unit based on successive layers of materials as described herein, then both the requirement that the figure of merit of each layer should have its maximum as closely as possible to the temperature at the location of the layer in the leg and the requirement that the ration of the CFs of adjacent layers must be less than two have to be satisfied.

The concept of the consistency factor explains why prior art thermo-electric models such as that shown in Fig. 1 are not efficient, especially when there is a large temperature difference between the hot and cold side. Referring to equation (7) it is seen that the CF is inversely related to the temperature. Therefore, in a thermo-electric structure whose legs comprise a single pellet, in which case both Z and $\alpha$ are constant, the dependency of CF on temperature indicates that the value of CF at the hot and cold interfaces can not be the same and therefore the efficiency of the thermo-electric leg will be reduced in all cases and seriously reduced if the temperature difference is large.

This problem of matching the consistency factors of the materials at the interfaces between levels can be overcome by breaking the dependency of the thermal conductivity and the electrical conductivity on each other. This dependency is a direct result of the fact that both the heat conduction and electric current flow take place through the legs of the thermo-electric structures. It is proposed that an electric circuit can be added to the thermo-electric structure to allow the electric current to flow externally to the material of the layers between layers having different consistency factors. One way to achieve separation between the thermal and the electrical conductivities is by using an electric wire with a diode in series that allows the electric current to flow outside of the leg while allowing the heat to propagate along the leg of the thermo-electric unit. In this case the design need only take into account the requirement on the figure of merit. The separation of electric current flow and heat flow is called by the inventors thermal-split, which is discussed in detail herein below.

- Diffusion may modify the chemical and physical properties of neighboring semiconductors. This effect can lead to deterioration of the thermo-electric properties of the successive layers. If this is the case, a protective layer (also called a passive layer, coating or a separation layer) should be added to prevent diffusion across the interfaces. The protective layer has to allow the transmission of heat and electric current while blocking elements such as dopants or metal atoms. Several different techniques can be used to prevent diffusion under different conditions of temperature and chemical surroundings. For example, the protecting layer can be deposited by evaporation, by washing with a chemical, or by plasma processes. Another method of forming a protective layer is to use polymers, which behave as a blocking net. It is not possible to give general recommendations herein concerning particular methods for forming and substances for use as a protective layer since the layer must be adapted to the materials on either side of the interface under consideration and will therefore be different for the thermo-electric structure of each specific device and application.

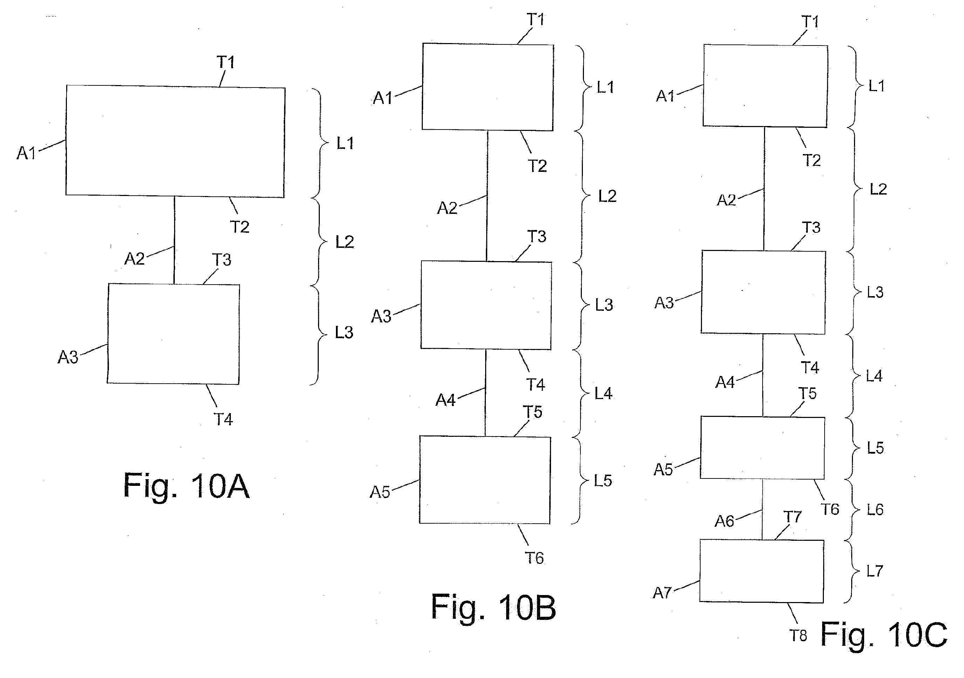

The basic split thermo-electric structure comprises one or a plurality of legs, each leg comprised of a chain of elements made of either n or p-type. This arrangement is able to solve many of the cooling and heat management problems of the prior art. Some examples of thermo-electric chains are shown in Fig. 10A to Fig. 10C. The transfer of heat through the structure can be determined by carefully controlling parameters such as the dimensions of each of each element, i.e. the thermo-electric elements and the hot and cold sides and also the elements that make up the intermediate connections, in the chain and also by properly choosing the type of material of each element.

As is well-known, thermo-electric modules have been extensively utilized for cooling. Clearly in most cooling applications the main requirement is to achieve maximum temperature difference between the cold and hot sides of the thermo-electric module. In prior art thermo-electric modules, the maximum achievable temperature difference $\Delta T_{max}$ results with an input current $I_{max}$, wherein $\Delta T_{max}$ and $I_{max}$ are given by:

$$\Delta T_{max} = T_h + \frac{1-(1+2T_h Z)^{0.5}}{Z} \qquad \text{equation (8a)}$$

$$I_{max} = (k_t \cdot A/L\alpha)((1+2ZT_h)^{0.5} - 1) \qquad \text{equation (8b)}$$

where;

$Z$ is the Figure of Merit (see equation (1))

$T_h$ is the temperature on the hot side of the module

kt is the thermal conductivity

A is the cross-sectional area of the pellet.

L is the length (height) of the pellet.

$\alpha$ is the Seebeck coefficient

In view of equation (8b), it is necessary to adjust the pellet dimensions A/L in order to set limits for the desired working electric current. In a typical thermo-electric module there are several hundred pellets, the ohmic resistance is a few ohms, the average pellet cross-section is A = 1.4x1.4 mm or 1x1 mm, and the pellet height is usually L=2-3mm. Thus, $\eta$ = L/A is generally of the order of 1.0 mm$^{-1}$.

In view of the relatively high ohmic resistance in the standard module, the heat flux on the hot side $Q_h$ is much higher than the cooling power $Q_c$ on the cold side. Consequently, large heat sinks must be used to dissipate the heat on the hot side. This is one of the critical disadvantages of standard thermo-electric coolers.

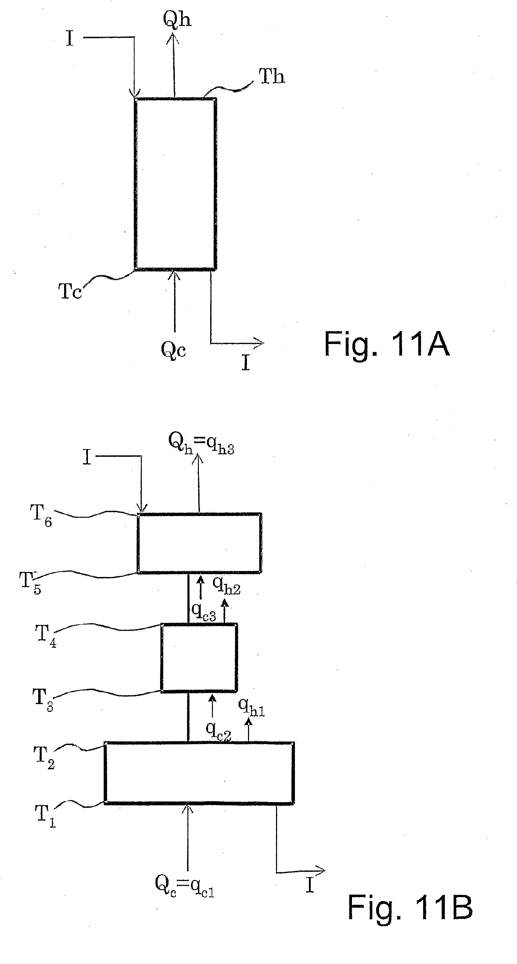

Fig. 11A illustrates the Peltier effect in an n-type element of thermo-electric material. When a current I flows in the direction indicated, then a temperature gradient is established and heat flows in the direction of the charge carriers (electrons in this case). If some mechanism is provided at the "hot" side for dissipating the quantity of heat $Q_h$ that "exits" the element at $T_h$, then, as long as the current flows, heat $Q_c$ at temperature $T_c$ will be drawn into the element from any object attached to the element at the "cold" side.

Referring to Fig. 11A, $Q_h$ and $Q_c$ are now presented in their classical forms:

$$Q_c = I\alpha T_c - I^2 R/2 - K\Delta T \qquad \text{equation (9a)}$$

$$Q_h = I\alpha T_h + I^2 R/2 - K\Delta T \qquad \text{equation (9b)}$$

Where, L and A are the length (height) and cross-sectional area respectively of the element, $T_c$ and $T_h$ are the temperatures of the cold and hot sides of the element, respectively; $\Delta T = T_h - T_c$, $\alpha$ is the average Seebeck coefficient, re is the electrical resistivity, kt is the thermal conductivity, and R and 1/K are the electrical and thermal resistances defined by:

$$R = r_e L/A = r_e \eta \qquad \text{equation (10a)}$$

$$K = k_t \, A/L = K_t/\eta \qquad\qquad \text{equation (10b)}$$

As $\eta = L/A$ is reduced, the Joule heat is moderated while the back diffusion term is enhanced. Hence, it is of high importance to control the relations between the Seebeck term ($I_\alpha T_c$), the Joule term ($I^2 R/2$), and the back diffusion term ($K\Delta T$). This can be partially achieved by utilizing material having the optimal figure of merit Z (see equation (1)) for the element.

In fact, the figure of merit Z represents a sort of weighted optimization for the combined effects of Seebeck effect, thermal conductivity and electrical resistivity. All of these properties are temperature dependent and therefore so is the parameter Z. However, as the thermo-electric element is subjected to temperature range, $T_h - T_c$, choosing the material having the optimal value of Z does not necessarily ensure the best optimization or the best combination of $\alpha$, Kt and $r_e$.

As is shown herein below, by controlling $\eta = L/A$ at the various zones the relative contributions of the various terms of equation (10a) and equation (10b) can be regulated individually and differently in the split structure chain of the types shown in Figs. 10A to 10C.

Fig. 11B illustrates the Peltier effect in a split thermo-electric chain of the type shown in Fig. 10B. The elements are all composed of n-type thermo-electric material. Referring to Figs. 10B and 11B, equations (9a) and (9b) can be expressed as follows for the first element of the thermo-electric chain:

$$q_{c1} = I\alpha T_1 - \tfrac{1}{2}I^2 r_e \eta_1 - k_t(T_2 - T_1)/\eta_1 \qquad\qquad \text{equation (11a)}$$

$$q_{h1} = I\alpha T_2 + \tfrac{1}{2}I^2 r_e \eta_1 - k_t(T_2 - T_1)/\eta_1 \qquad\qquad \text{equation (11b)}$$

Where, $\eta_1$ refers to the dimensions of first thermo-electric element in the chain. Similar equations can be written for the other elements as well as for the intermediate connections, each having its unique $\eta_i$.

At the inter-facial surfaces between the elements in the chain, i.e. the thermo-electric elements and intermediate connections, the heat flux leaving one element may be equal to that entering the next element or partial heat loss to the surroundings can be taken into consideration. Moreover, along the various elements and connectors the equations may assume complete thermal isolation or be adapted to take into consideration heat convection according to the specific application under consideration.

Clearly, in view of the equations (11a) and (11b) it is desirable to work at high Seebeck coefficient and low electrical and thermal resistance. However, thermo-electric materials with high Seebeck coefficient also have high electrical resistivity causing high Joule effects. Instead of moving to an optimal Figure of Merit, i.e. intermediate $\alpha$, $r_e$ and $k_t$, to compensate for all effects, it is proposed herein to dramatically reduce the Joule term by operating with sufficient low $\eta_i$. By adjusting the dimensions of the elements in the thermo-electric chain it is possible to work with materials having high Seebeck coefficients, (with high resistivity, re) and low thermal conductivity $k_t$ and thereby optimize the accumulated heat transfer effect across the structure. Thus, in equations (11a) and (11b), the Seebeck term can be made to reach its maximum while the magnitudes of the Joule and back-diffusion terms are reduced. Consequently, the cooling power of the element is enhanced and the number of elements needed to transfer the heat load decreases accordingly.

As mentioned above, equations similar to equations (11a) and (11b) are constructed for each of the thermo-electric elements and connectors in the chain and solved to determine the value of $\eta_i$ for each element in the chain that will optimize the corresponding Joule effects or the back-diffusion effects according to the constraints of a given application. Examples of constraints are: to minimize the number of chains needed to cool a given object; to minimize on the heat dissipated at the hot side; or to minimize the input power.

Electronic devices and components are frequently subjected to varying heat flux and their performance is affected significantly by the working temperature range. Most systems aimed at stabilizing the temperature range are associated with relatively long-time constant. Therefore most systems introduce a long-time delay resulting in a wide temperature operating range. Also in the prior art a wide range of temperature is the result of cooling systems that are not design to manage heat precisely. For example, a fan is used to cool processor chips however, its response time is long and the precision with which it dissipates heat is poor.

For most electronic components, the performance can be maintained and even upgraded if the temperature is restricted to a limited, narrow range. Temperature control and heat flux management can be precisely regulated by utilizing thermo-electric cycles. The external current applied to the thermo-electric circuit can easily be changed in magnitude and direction and thus, heat flux which is drawn to or withdrawn away from the regulated surface is effectively controlled with high precision.

Using prior art thermo-electric modules the temperature can be maintained within a narrow range of $\pm 0.1°C$ of the desired temperature. However, in order to accomplish this, the heat dissipation mechanism must be compatibly efficient and the released heat must be sent off as soon as possible. Moreover, it is crucial that the heat regulator, which in this case is the thermo-electric cycle, will not insert noise, i.e. self-heat power, into the close environment of the object to be controlled. Using conventional thermo-electric modules it is not easy to solve the problem of heat dissipation.

The split structure comprised of a chain of thermo-electric elements proposed in this invention provides all possible degrees of freedom, including:

(a) Because of the split structure the heat produced by the sensitive object is sent far away from it.
(b) The split structure allows complete freedom to choose the best and most individually efficient dimensions for the thermo-electric elements at each stage in the thermo-electric chain.
(c) The effects of Joule ("parasite") heat development and the back-diffusion effects are significantly reduced allowing the designer to choose materials that have high Seebeck coefficients.
(d) The time constant can be controlled by regulating the distance between the elements and their dimensions and properties.
(e) The thermo-electric current can be adjusted to both low heat flux and high heat flux conditions, wherein the case of high heat flux corresponds in fact with significant cooling and simultaneous temperature stabilization.
(f) The requirements of any specific application, e.g. the temperature range, the minimal number of elements, the minimal heat dissipation, or the power input, can be obtained by a comprehensive optimization using equations 5 (a) and 5(b).
(g) By reversing the current, cooling or heating effects can be analyzed and structures designed accordingly.
(h) The load on the various elements in the thermo-electric chain is not uniform, e.g. the upper element at $T_h$ is overloaded compared to the lower absorbing element at $T_c$. Standard thermo-electric modules should run at a constant current. In the chain structure of split elements, different values of electric current may be caused to flow through different elements in the chain. Specifically, if a higher current flows through the element at $T_h$ than through the element at $T_c$, a higher value of $\Delta T$ or higher cooling heat power can be achieved. A more detailed explanation and examples of how current-split can be accomplished will be presented herein below.
(i) The temperature of an object can be stabilized at a target-temperature by use of a feedback system. There are several feedback systems that can be used with the split thermo-electric structure. One example of a feedback system that is very easily used in conjunction with a split thermo-electric chain structure comprises a thermocouple that is used to activate a power supply. When the thermocouple senses a deviation from the required temperature, a current is then supplied to the split structure to compensate for the temperature change, wherein the split structure can supply either heating or cooling depending on the direction of the flow of the current through the thermo-electric leg. One or more thermocouples can be located to sense the temperature at any location on the chain thereby optimizing the performance by controlling the temperature distribution along the chain.

## Example 1

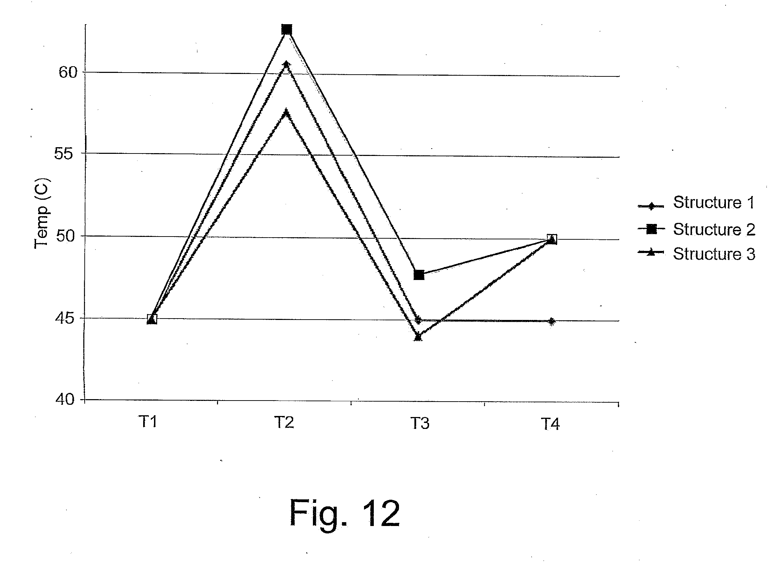

Three split thermo-electric chains similar to those shown in Fig. 10A are determined. For all three structures: L2=40mm, L3=1mm, A2=7mm², A3=16mm², I=20A, and T1=45°C. The predetermined values of L1, A1, and T4 and the values of T2 and T3 calculated using the given values of the other parameters are shown in Table 1. Heat transfer simulations were carried out using equations (11a) and (11b). The simulations were performed for $Bi_2Te_3$ whose thermo-electric properties are: $\alpha=200\mu V/K$, $r_e=10\mu\Omega{*}m$, and kt=1.4W/Km. The values of the electric contact (the metallic conductor tabs) were simulated for copper, i.e. $\alpha=2\mu V/K$, $r_e=10\mu\Omega{*}m$, and $k_t=400W/Km$. The temperatures at the interfaces between the elements of the chains are shown in Fig. 12.

## Table 1

| Structure | L1 | A1 | T2 | T3 | T4 |
|---|---|---|---|---|---|
| 1 | 1 | 16 | 61 | 45 | 45 |
| 2 | 1 | 16 | 63 | 48 | 50 |
| 3 | 0.5 | 12.25 | 58 | 44 | 50 |

### Example 2

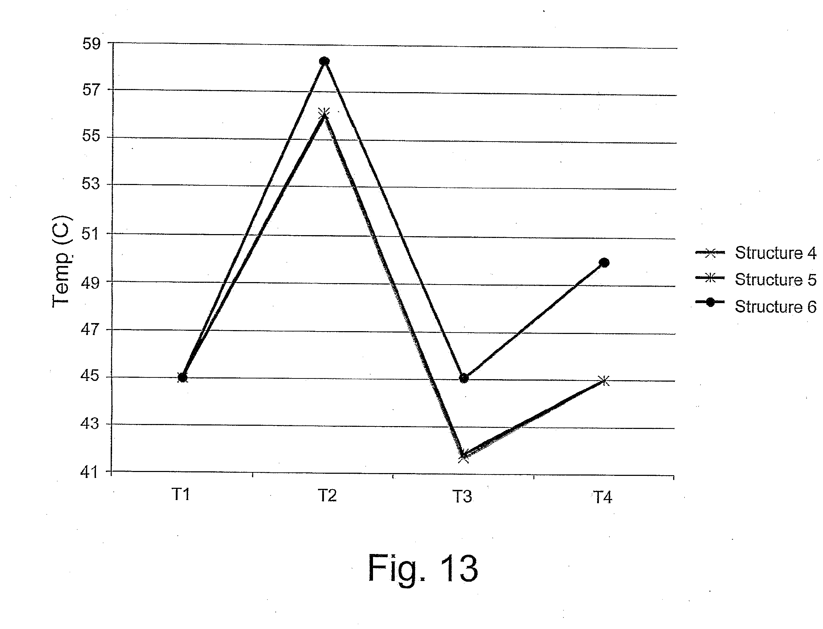

Three more split thermo-electric chains similar to those in example 1 are determined. For all three structures: L1=0.5mm, L2=40mm, A1=12.25mm$^2$, A2=7mm$^2$, A3=16mm$^2$, I=20A, and T1=45°C. The predetermined values of L3 and T4 and the values of T2 and T3 calculated using the given values of the other parameters are shown in Table 2. Clearly all other parameters, e.g. $q_c$ and $q_h$ vary accordingly. The temperatures at the interfaces between the elements of the chains are shown in Fig. 13. The simulations were performed for thermo-electric parameters as in example 1.

## Table 2

| Structure | L3 | T2 | T3 | T4 |
|---|---|---|---|---|
| 4 | 1 | 56 | 42 | 45 |
| 5 | 0.5 | 56 | 42 | 45 |
| 6 | 0.5 | 58 | 45 | 50 |

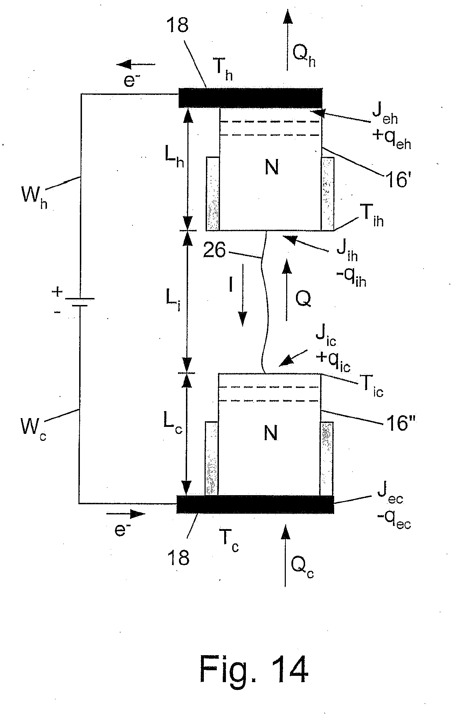

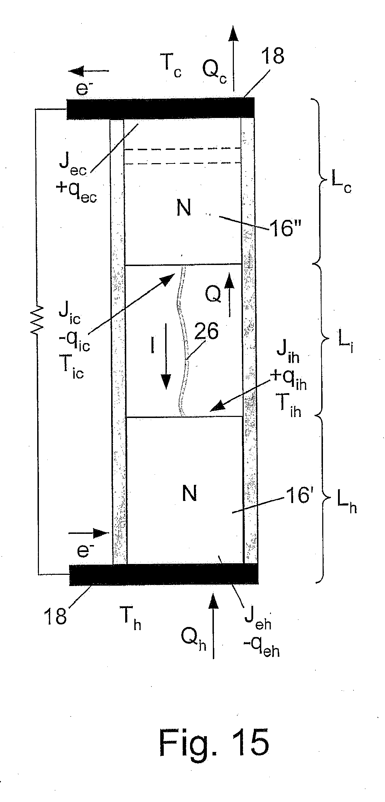

Fig. 14 and Fig. 15 schematically show the basic schemes for one-type one-leg thermo-electric circuits for cooling and power generation, respectively.

In Fig. 14 and Fig. 15 the following notation is used:

- $Q_c$ = the heat absorbed at temperature $T_c$ on the cold side (Fig. 14) = the heat dispersed at temperature $T_c$ on the cold side (Fig. 15);
- $Q_h$ = the heat dispersed at temperature $T_h$ on the hot side (Fig. 14) = the heat absorbed at temperature $T_h$ on the hot side (Fig. 15);
- Q = the heat flow through the thermo-electric leg;
- I = the flow of electric current through the thermo-electric leg;
- $e^-$ = the electron flow;
- $J_{eh}$, $J_{ec}$, $J_{ih}$, and $J_{ic}$ = the external and internal junctions at the hot and cold sides respectively;
- $q_{eh}$, $q_{ec}$, $q_{ih}$, and $q_{ic}$ = the Peltier heating effects at the external and internal junctions at the hot and cold sides respectively, wherein + means that heat is dissipated and - means that heat is absorbed at the junction;
- $T_h$ and $T_c$ are the temperatures at the hot and cold external junctions respectively;
- $T_{ih}$ and $T_{ic}$ are the temperatures at the hot and cold internal junctions respectively;
- $L_c$, $L_h$, and $L_i$ are the height (length) of the pellet on the cold side, the pellet on the hot side, and the intermediate level respectively;
- $W_h$ and $W_c$ = the Joule heating in the external circuit;
- the thick gray lines represent thermal insulation;
- the dotted lines inside the pellets represent porous material;
- 18 = conducting tab;
- 16' and 16" = the hot and cold side pellets respectively; and
- 26 = intermediate connections.

Any thermo-electric system or device includes the simultaneous flows of heat and electric current (electrons in the case of n-type material, holes in the case of p-type material). The split-structure also includes some additional physical phenomena taking place at the interior thermo-electric junctions. The phenomena that must be taken into account are heat absorption and dissipation at the cold and hot zones respectively, heat transfer between the environment and elements of the thermo-electric leg, Joule heating ($Q_j = I^2 R$) for each material in the thermo-electric legs and external connections, and Peltier heating/cooling at the internal and external junctions.

The split structure makes possible practical intervention at the location of these local physical phenomena that enables optimization of the power output or heat transfer of the thermo-electric structure. In the standard thermo-electric module no intervention can be made into the module and all that can be done to improve the performance is to try to optimize the heat sink or heat source zones. The practical intervention is accomplished by making modifications to the elements that comprise the legs of the thermo-electric structure or in some cases to the entire structure.

For the case of cooling applications (Fig. 14) it is important to maximize $Q_c$, i.e. the quantity of heat absorbed at the cooled side and transferred to the hot side. This requires that no additional thermal load be introduced to the thermal flow in its path from the cold zone to the hot zone. Therefore, several measures should be taken:

(a) Thermal insulation should be applied to the zones where negative Peltier effects takes place, i.e. at Jec and Jih, in order to prevent heat input from the environment. It is important to try to insure that only heat from the target, i.e. the object to be cooled, is transferred.

(b) On the other hand, at junctions Jic and Jeh, where positive Peltier effects develop, it is required to enhance the heat dissipation from the pellets to the environment. This can be achieved for example by forming a porous structure for the pellets in those zones (indicated by the dotted lines in the figure) or by use of a good thermally conducting metallic porous envelope.

(c) Also, it has been found that enhancing the heat transfer at $J_{ic}$ from the intermediate conductor to the surroundings will reduce the thermal load and allow more efficient heat transfer of $Q_c$.

(d) Care is to be taken at the wiring connection at Jec to minimize the external load which may diffuse into the cooling system due to Joule-effect in the connection wiring, $W_c$. Similarly, the heat transfer through the connection wire at the hot zone, Wh is to be enhanced. Both $W_c$ and $W_h$ can be made of non-insulated porous conductor material with maximum peripheral area.

(e) Enhancing or reducing the heat transfer can be accomplished by changing the cross-sectional area of the pellet, e.g. by using pellets having a frusto-conical shape.

Referring now to the power generation scheme shown in Fig. 15, the operational configuration is in essence similar to that of cooling circuits. From the practical point of view, the heat absorption Qh, i.e. the quantity of heat absorbed at the hot side and transferred to the cold side is now the triggering parameter which determines other operational parameters, e.g. internal temperatures and the output current I. Note that in the case of a cooling circuit the triggering parameter is in fact the current I, which determines the value of the other parameters, e.g. Th, Tc, Qc, Qh. With the directions of the heat flux input Qh, heat flux Q, and the electron flow e⁻ as shown in Fig. 15 the direction of the resulting current I is in the direction opposite to that shown in Fig. 14 for a cooling situation. However, since the goals in Fig. 14 and Fig. 15 are different, the intervention in the associated physical systems and processes should be made in accordance with the application. In the cooling cycle it is necessary to eliminate or reduce the extra-thermal load which may come from the outside in order to maximize Qc. In the case of power generation, the optimal current, I, is obtained by the optimal heat flux which flows through the thermo-electric elements. The greater AT, the more power can be derived. In order to maintain an optimal temperature drop AT and the highest heat flux, Q and in view of Fig. 15 the following measures should be carried out:

(a) In this case the entire path of the heat flow through the thermo-electric leg should be thermally insulated from the surroundings.

(b) The heat transfer to the environment at Tc is to be enhanced to keep Tc as low as possible.

(c) As opposed to the cooling scheme, the choice of the thermo-electric materials and conductors is aimed at reducing the Peltier effects at Jec and Jih.

It is of utmost importance to emphasize that special care is to be taken in adopting the thermo-electric material at the hot and cold zones to the temperature range at these zones. The split structure opens the possibility of choosing the thermo-electric material locally accordingly to the physical situation of the application under consideration.

In view of Fig. 14 and Fig.15 it is of interest to note some of the effects and trends of system parameters. Knowing the trends of the various parameters will provide the designer with the knowledge necessary to optimize the system performance. The effects of the various parameters can be obtained from a comprehensive physical analysis. For the purpose of illustration, the physical system of power generation, according to Fig. 15, is analyzed. Assuming an application whereby a heat flux $q_h$ is impinging on the external surface of the hot zone pellet, and an effective insulation through the pellets and connector (as is usually required in power generation scheme - see above), the heat transfer equations through the hot connector and cold zones yield;

$$T_h - T_{ih} = G_h L_h^2 + \frac{q_h L_h}{k_h} \quad ; \quad G_h = \left(\frac{g}{2k}\right)_h \qquad \text{equation (12)}$$

$$T_{ih} - T_{ic} = G_i L_i^2 + \left(\frac{g_h L_h + q_h}{k_i}\right) L_i \qquad \text{equation (13)}$$

$$T_{ic} - T_c = G_c L_c^2 + \frac{\left(g_h L_h + g_i L_i + q_h\right)}{k_c} L_i \quad ; \quad G_c = \left(\frac{g}{2k}\right)_c \qquad \text{equation (14)}$$

$$H\left(T_c - T_\infty\right) = q_h + g_h L_h + g_i L_i + g_c L_c \qquad \text{equation (15)}$$

where, $g_c$, $g_h$, and $g_i$ = the heat generation rate per unit volume in the pellet on the cold side, the pellet on the hot side, and the intermediate level respectively; H = the convective heat transfer coefficient; and $T_\infty$ is the ambient temperature on the cold side.

The principles discussed herein above suggest the possibility of creating thermo-electric structures comprising a single leg instead of the conventional two-leg structure. In the one leg modules each leg consists of two thermo-electric pellets with a connection layer between them in a split structure. The one leg structures can be comprised of two n-type pellets or two p-type pellets at the heat absorption and heat dissipation sides respectively. Since at the present state of the art, n-type material gives better results than p-type using only n-type material is preferred for most applications.

One-leg one-type split thermo-electric structures can solve many of the cooling problems in the fields of electronics and microelectronics. One n-type pellet in the form of a single crystal can be attached directly to a printed circuit, an individual chip, or processor, e.g. by gluing or even growing it on the back of a semiconductor element, and used to absorb the heat generated by them. This pellet will be connected by a connection layer, e.g. a wire, to another n-type pellet made of a different material which will be in thermal contact with a heat sink to dissipate the heat absorbed by the first crystal. The heat sink can be for example the metal case that surrounds the elements being cooled. As will be described in more detail herein below, the crystal attached to the element being cooled can be connected to several pellets disposed at different locations on the case via more separate intermediate layers to allow efficient dissipation of the heat. Thus, the principle of one-type one-leg thermo-electric circuit can be used to design cooling systems which can be built right into micro-chips reducing or eliminating the need for separate cooling system and replacing the ventilator fans and heat sinks used today in devices such as PC and laptop computers and in communication cabinets.

Because of the Peltier effects at the internal junctions, instead of using p-n semiconductor pairs, a complete thermo-electric module can be constructed by appropriately connecting only n-type or only p-type pellets. The motivation for doing this is that in practice, because of limitations of the thermo-electric materials, the efficiency of thermal and electrical conductivity of the n-type and p-type legs in a thermo-electric structure (module) is not the same. Building a thermo-electric structure having legs of only the most efficient (for the particular application) type of semiconductor material will help to maximize the overall efficiency of the structure. Also, although the pellets on both side of the leg can be made of the same thermo-electric material, for reasons explained herein, the structure will be more efficient if different n-type (or p-type) materials are used to match the Z factor of the material to the temperature at the hot and cold sides respectively.

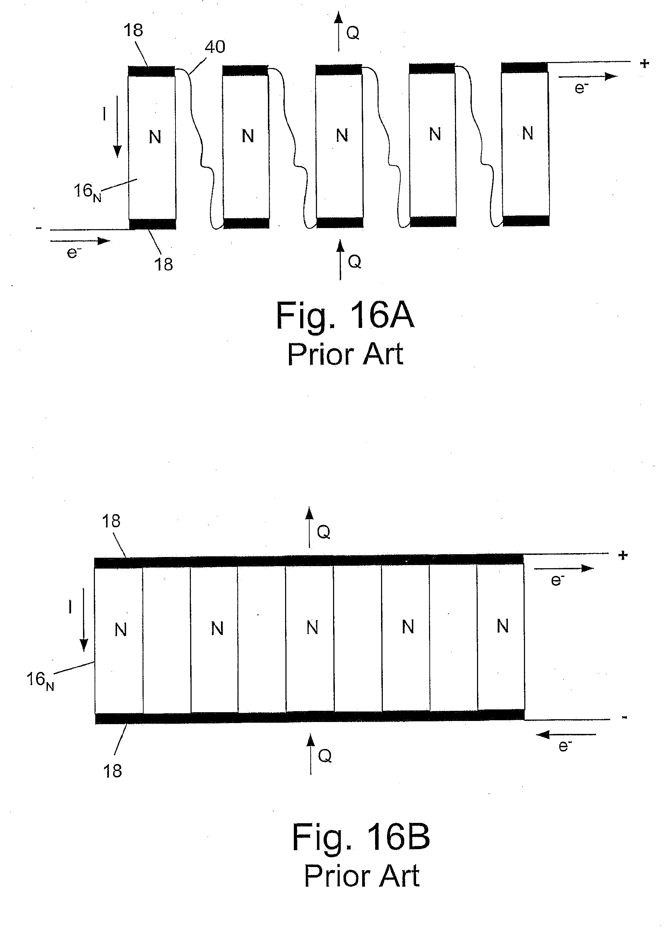

Fig. 16A and Fig. 16B illustrate two ways of constructing single-type thermo-electric modules that have been considered in the prior art. In principle, both configurations are workable however, in practice neither has resulted in a useable thermo-electric device. The parallel connection shown in Fig. 16B looks to be simple and easy to construct; however it can not be used from the "practical" point of view since, for a relatively small potential difference, the numerous pellets draw a very large electric current. The one-type arrangement shown in Fig. 16A, in which the pellets are electrically connected in series by electric connectors 40 clearly requires more complicated electric connections and for the typical tight prior art modules (usually 2mm. in thickness) dramatic thermal shorting develops, which may rapidly terminate the thermo-electric effects.

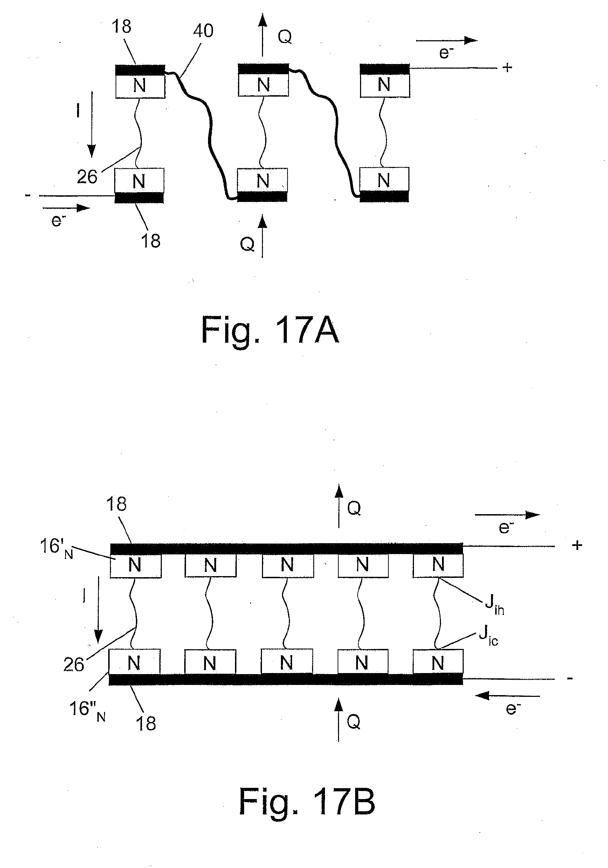

The split thermo-electric structures that are discussed herein above can be applied to allow realization of series or parallel one-type thermo-electric circuits as shown schematically in Fig. 17A and Fig. 17B respectively. It is noted that the one-type thermo-electric structures of the invention can be either n or p-type. At the present stage of development of thermo-electric materials n-type materials generally have higher thermo-electric efficiencies than p-type materials, although this may change in the future. In any case the material should be selected according to the principles discussed herein in order to give the optimal results for a given application.

The one-type circuits constructed based on the split structure are not restricted to low numbers of split pairs in order to reduce the electric current load. Using the split-structure the thermo-electric pellets can be far larger than the 1-1.4 mm pellets that must be commonly used in prior art modules in order to meet the requirements of tight structure with very flat surfaces and even pressure exerted on all of the pellets by the ceramic plates. This in connection with the use of intermediate connections of appropriate length allows separation of the hot and cold zones removing the problem of thermal shorting. In general with the split-structure concept, the problems that have made the proposed prior art solutions shown in Fig. 16A and Fig 16B impractical are eliminated. In particular new ways of design, having a variety of advantages and degrees of freedom, are made available by using the principles shown in Fig. 5 and Fig. 6 to provide legs comprised of several layers of thermo-electric and conducting materials having different figures of merit and/or dimensions selected in order to optimize the value of the figure of merit to the local temperature at different positions along the leg.

In the split structures described herein above there is a one-to-one relationship between the number of thermo-electric elements at the heat absorbing and the heat dispersing sides of the structure. Each n or p-type element on the heat absorbing side is connected through a leg to an element of the same type on the heat dispersing side. As in the case of prior art thermo-electric modules, both heat flux and electric current flow through each of these legs.

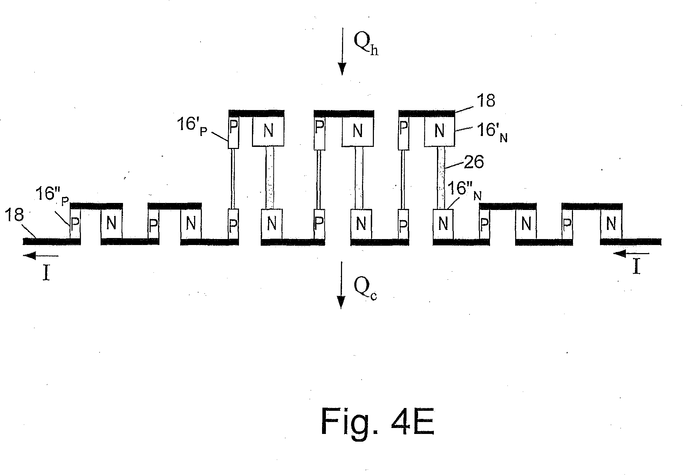

The split thermo-electric structure however allows much greater flexibility in designing thermo-electric structure taking advantage of previously unthought-of ways of modifying the structure in order to increase the overall efficiency of structure based on it. For example Fig. 4E schematically illustrates an embodiment of a split thermo-electric structure in which the on-to-one relationship discussed in the previous paragraph is broken. In the structure shown in Fig. 4E additional pairs of p,n elements have been added by electrically connecting them in series to the pairs of elements on the heat dispersing side of the core of the thermo-electric structure shown in Fig. 4D. Proper choice of the material of the additional p.n elements in accordance with the principles described herein above can dramatically increase the ability of the structure to disperse the heat absorbed at the heat absorbing side.

Consideration of the split structures for thermo-electric structures has suggested to the inventor three new methods that can be used to optimize their output in either heating, cooling, or power generation applications based on the principles described herein. These methods have been named by the inventors thermal-split, power-split, and current-split.

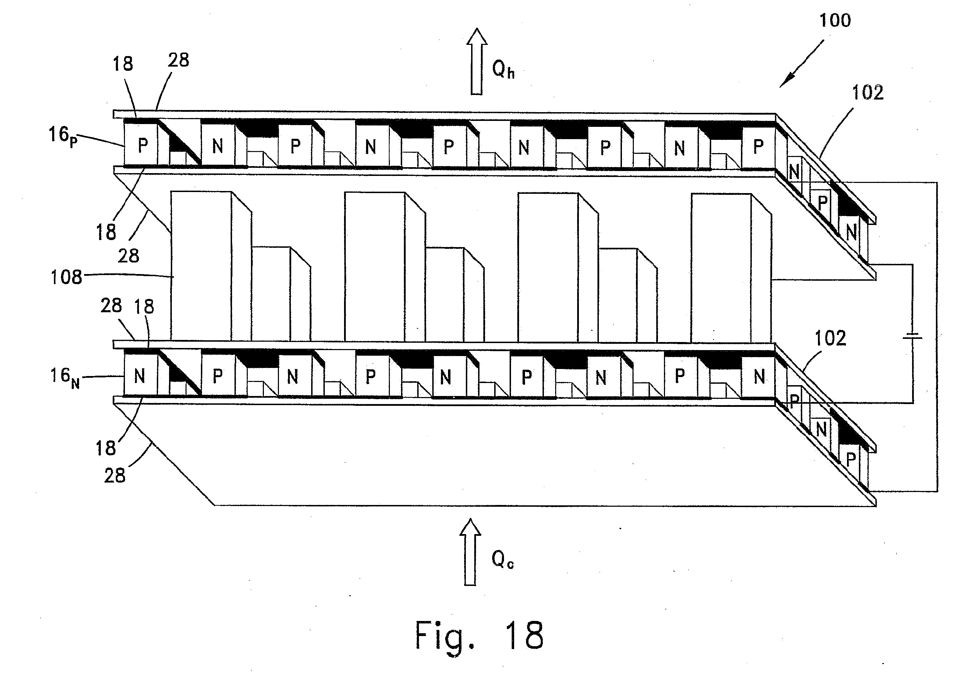

The thermo-split structure allows the transport of the electric current to be disengaged from the flow of heat in thermo-electric structures. The basic thermo-split structure 100 is schematically shown in Fig. 18. The "hot" and "cold" sides of the thermo-split structure 100 are each comprised of a sandwich layer 102 containing a plurality of n-type and p-type legs $16_n$ and $16_p$ sandwiched between two support layers 28 and connected electrically in series by means of metallic conducting tabs 18. For simplicity legs $16_n$ and $16_p$ have been drawn as single pellets but they can be more complex multilevel structures such as those shown in Fig. 5 and Fig. 6 with the materials chosen to maximize the heat flow through the legs according to the principles discussed herein above. Also there doesn't have to be symmetry between the sandwich layers 102 at the hot and cold sides of structure 100, i.e. the number of legs, their structure, and the choice of materials is chosen to maximize the heat flow at each temperature regime.

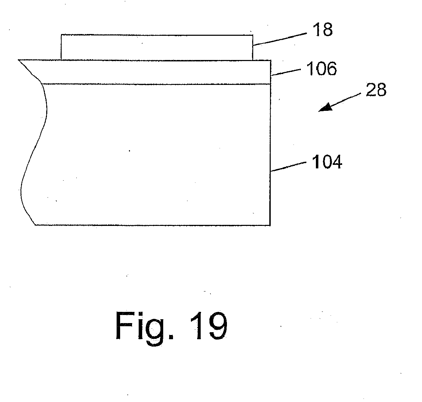

In Fig. 18, support layers 28 appear to be rigid plates; however in practice support layers 28 can be rigid or flexible allowing them to be matched to the contours of heat or cold sinks if required by the application. The function of the support layers 28, in addition to maintaining the physical unity of the structure is to transfer heat as efficiently as possible while blocking the transfer of electric current. One example of a support layer 28 is shown schematically in Fig. 19. Seen in this figure is a thin copper plate or copper foil 104 that is coated with a layer of non-electricity conducting material 106 such as epoxy. Another option for a support layer is a conventional PCB. In both cases a pattern of metallic conducting tabs 18 is created on the surface of the support layer to which the thermo-electric elements $16_n$ and $16_p$ are connected, e.g. by means of an appropriate glue. In another embodiment the entire sandwich layer, including "growing" the semiconductor elements $16_p$ and $16_n$ on the conducting pads 18 can be created using conventional techniques employed in the semiconductor industry. An illustrative indication of typical dimensions that could be appropriate for a thermo-split structure is: copper layer 104 - 1mm thick, epoxy layer 106 - 50 $\mu$m thick, and copper tab 18 - 100 $\mu$m thick.

The sandwich layers 102 at the hot and cold sides of structure 100 are electrically connected by external electric conductors, e.g. copper wires, as shown in Fig. 18 to form a complete series electric circuit. Fig. 18 shows a heating/ cooling application but obviously an electrical load can replace the dc power source in a power generation application.

Heat is transferred between sandwich layers 102 at the hot and cold sides of structure 100 by means of heat transfer devices 108. In both conventional modules and the split thermo-electric structures the heat transport between the cold and hot zones is carried out mainly by conduction through the pellets and intermediate connectors. The thermo-split structure opens new ways to utilize other means for transferring the heat flux between the two layers, e.g. heat pipes or a combination of conduction carriers and heat pipes. It is noted that the heat pipe body may be used as a heat conducting media for low heat flux and the heat pipe mechanism be activated for higher heat flux. It is also noted that, as opposed to conventional thermo-electric modules and also the newly developed split thermo-electric structures described herein, using the thermo-split structure each pellet in the heat absorbing side of the structure does not have to be connected to a corresponding pellet in the heat dispersing side by means of an intermediate connectors. Also the number of pellets in the sandwich layer on the hot side does not have to equal to that on the cold side. The number of pellets in the sandwich layer on each side, the material of which they are composed, as well as the number of heat transfer devices can be determined using the principles described herein to maximize the heat transfer (or power produced).

In general, it is worth noting some distinctions between the split thermo-electric structures in which the electric current and heat flow simultaneously through the legs of the structure and the thermo-split structure:

(a) The electric-split is best for absorption and transfer of heat flux in uniform mode. It is preferable for homogeneous and uniform density of thermo-electric elements. In addition, for low cooling, heating, or power capacity the number of pellets is low and the intermediate connector body can be thin and very flexible.

(b) The thermo-split structure is more suitable for rigid structures where flexibility of the intermediate connection is not a requirement. This might be the case of high numbers of elements (higher power capacity), in which case the heat transfer devices will have a relatively large cross-sectional area. The thermo-split structure can easily account for varying density of thermo-electric elements (in case of hot spots or non-uniform heat release) by appropriately locating heat transfer devices 108 and adjusting their parameters to enable them to effectively cope with the local heat transfer requirements.

It is true that the thermo-split structure might appear rigid compared to accomplishing heat transfer between the two sides of the structure using a large number of wire-like intermediate connectors as in the regular split approach; but, on the other hand, the use of larger cross-sectional area heat transfer devices reduces the electrical resistances of the intermediate connector body. Hence, the consumption of the external power may be reduced.

(c) The thermo-electric equations discussed herein above show that there is an optimal value of $\eta = L/A$ ($L$ is the pellet height and $A$ is its cross-section), for which the number of thermo-electric elements is minimal. For smaller $\eta$ the power consumption is lower while the number of elements required may increase. On the other hand the numbers of pellets may be reduced by using larger cross-sectional intermediate connectors. While this relationship between $\eta$, the number of thermo-electric elements, and the power consumption may be a limitation in the split thermo-electric structures described above, it is much easier and simpler in the thermo-split structure to significantly increase the area for the heat transfer (the heat flux carrier). This allows the use of a lower number of thermo-electric elements as well as lower electricity consumption. In other words, with the thermo-split structure, the optimization procedure for the thermal transport can be decoupled from the optimization of electricity consumption and/or the number of thermo-electric pairs required.

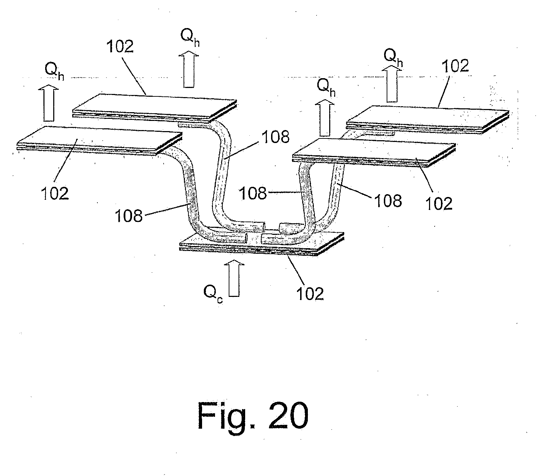

One of the most important features of the split structure is the degree of freedom it allows to also split the operation power of the thermo-electric device. With the thermo-split concept, the heat flux can be easily split to more than one location as is schematically shown in Fig. 20.

The split of the heat power to multiple locations can be adopted also in the split thermo-electro structures that don't employ thermo-split as has already been discussed herein above with respect to the one leg solution of the cooling problems in the fields of electronics and microelectronics. However, power-split is much simpler when used in conjunction with thermo-split.

In principle the power-split reduces the critical requirements for large heat distributors at the hot zone. The use of one 'heat focus' at which the heat is dissipated, as in Fig. 18 for instance, creates an intensive heat spot which affects all upwards temperatures $T_1$ $T_2$, $T_3$, $T_4$ ..., (Fig.11B) and thus reduces the capacity of power absorption of the lower level (cold zone) as well as the ability to stabilize and control the temperature at the absorption surface, $T_1$.

The power-split to a number of "heat foci" at which the heat is dissipated, e.g. located on different walls of the metal case surrounding the processor of a computer, as shown in Fig. 20 results in the reduction of the whole temperature profile along the entire thermo-electric system, and thus moderates the requirements for the heat sink and for heat distribution at the hot zone. Practically by moderating the heat density and distributing the heat at the hot surface utilizing the power-split concept possibilities for higher and more intensive cooling capacities are made available to system designers.

The new split structures proposed herein, also offer the possibility of utilizing current-split in thermo-electric structures. By current-split it is meant that the electric current at the split thermo-electric layers, i.e. at the cold and at the hot zones, are fed by different levels of electric current. Standard thermo-electric modules utilize a given electric current flowing in series through all thermo-electric pellets. However, as is well known the thermal load at the heat absorbing cold side may be much lower than that at the heat rejecting hot side. Utilizing high current for both zones causes unnecessary high Joule heating effects. It has been shown by the inventors using the principles discussed herein that by applying reduced current at the absorbing zone while applying higher current at the heat releasing surface reduces the overall power consumption of the thermo-electric structure and enhances the cooling capacity. Clearly this mode of current-split cannot be applied to standard thermo-electric modules.

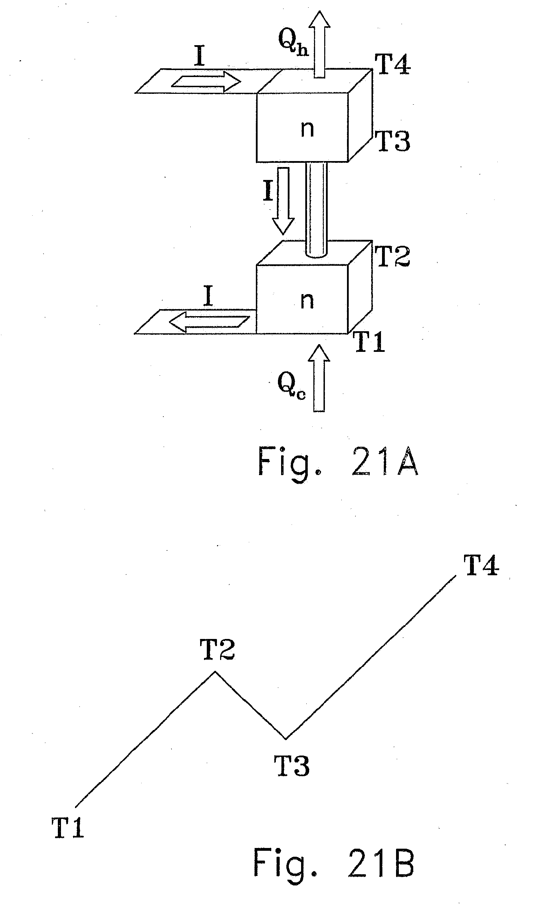

The concept of current-split is not to be understood only in a simple way, i.e. only that the values of current at the hot and cold zones are unequal. It is true that first of all the electric current is unequal at the heat absorbing pellets and at the heat distributing pellets. However, in addition, the split structure as a whole enables a variety of intrinsic arrangements of the pellets that may control the heat generation at the internal thermo-electric junctions. Examples of some configurations of thermo-electric structures using the current-split concept are symbolically shown in Fig. 21A to Fig. 25.

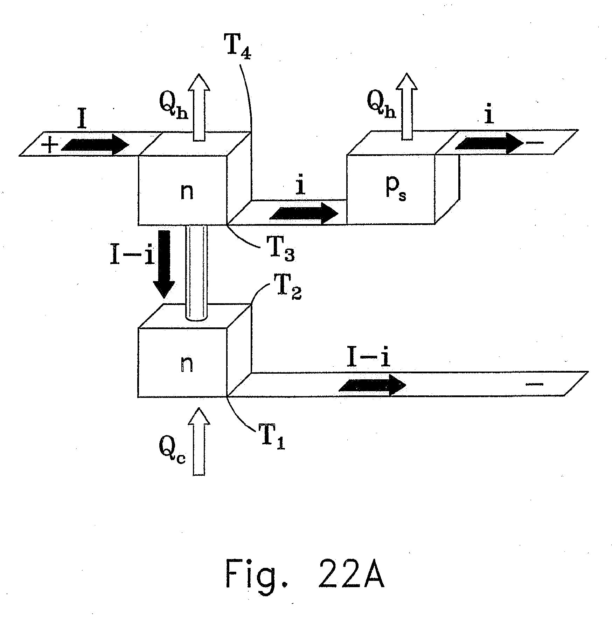

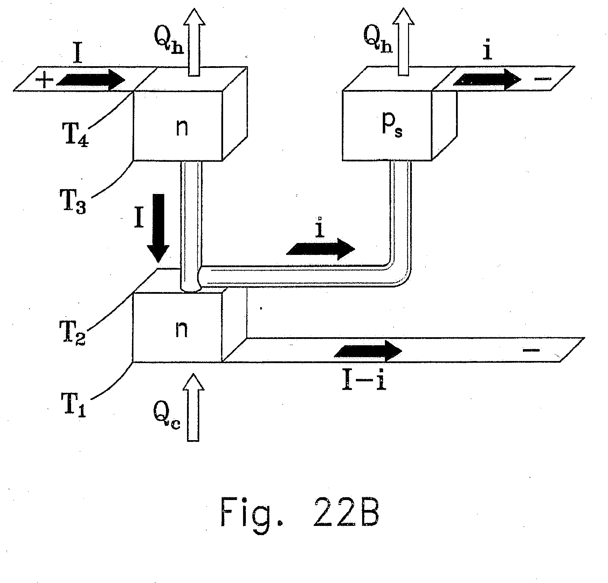

Fig. 21A shows the simple split structure, whereby the temperature profile at the various junctions, determined using equations (11a) and (11b), is shown in Fig. 21B. Figures 22A and 22B demonstrate two variations of splitting the current, while introducing a p-type element, designated $P_s$, at the interior junctions Jih or Jic respectively. In the figures I is the current introduced into the thermo-electric structure and i is the current split off from I. The value of i can be adjusted by changing the electrical resistivity of the added pellet $P_s$. The p-type element that is introduced serves as a point absorber of heat from the interior thermo-electric junctions and therefore directly affects T2 and T3. In fact, the whole temperature distribution shown in Fig. 21B is reduced to a lower level by splitting the current as shown. It is noted that in a p-type leg, an n-type element designated $N_s$ is introduced to accomplish the power split. For a given overall electric current I, the current-split structure of Fig. 22A and Fig. 22B results in lower power consumption and higher power cooling compared with the simple split structure of Fig. 21A without current split.

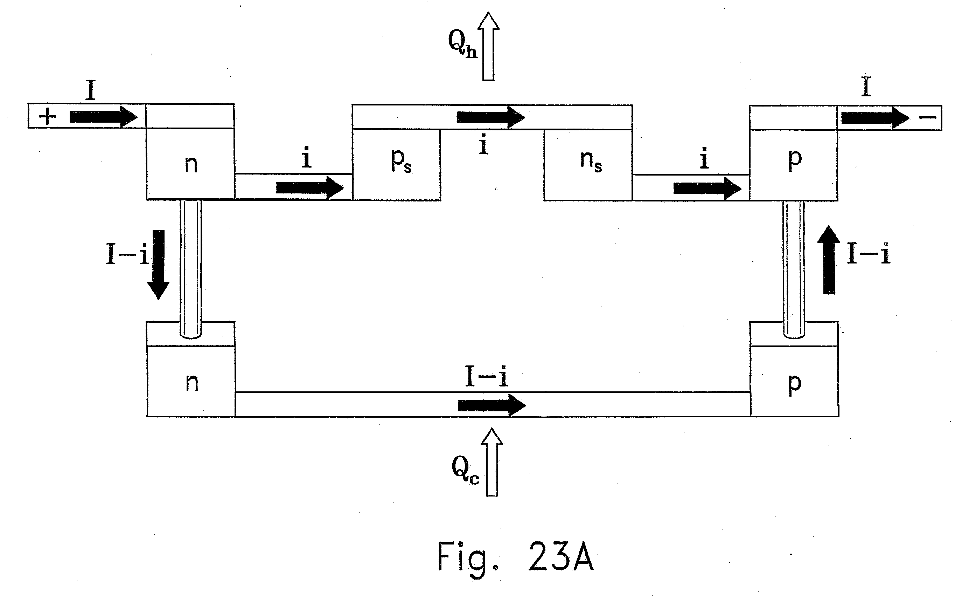

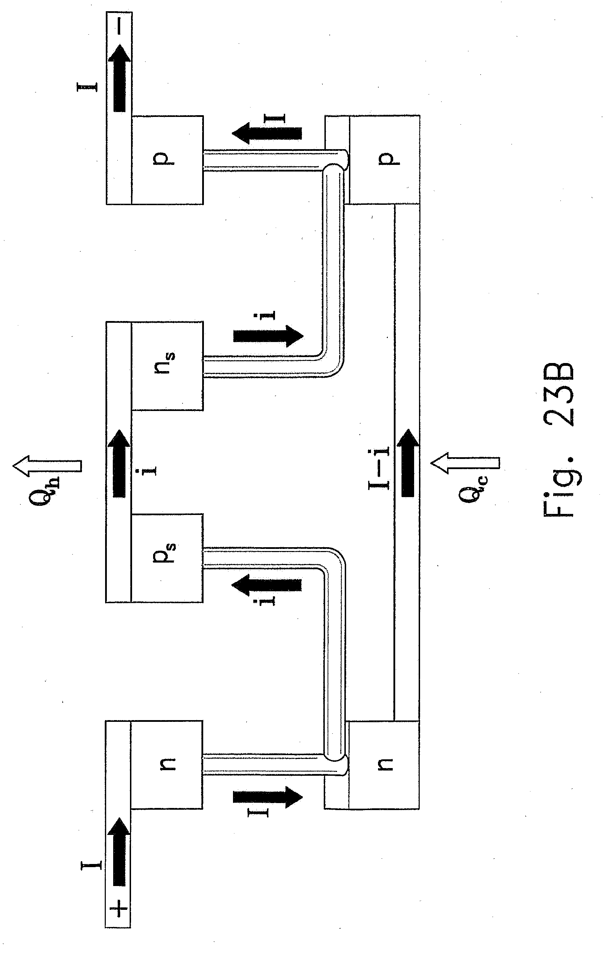

Figures 23A and 23B symbolically show a complete thermo-electric unit based on the current-split structures of Fig. 22A and Fig. 22B respectively. The structures of Fig. 7A and Fig. 7B are easily carried out by utilizing PCB circuits for the upper and lower layers, where the upper layer is associated with the heat distributor and the lower layer is associated with the zone to be cooled or temperature controlled.

The split structures as shown in Fig. 23A and Fig. 23B relate in general to thermo-electric systems and devices, where the heat source and heat sink are remote from one another. However as the distance between the layers is reduced to its possible minimum, these approach again a compact new thermo-electric module, with split thermo-electric elements, split electric current, and which includes additional $P_s$-$N_s$ enhancers. Such modules can be designed for a wide spectrum of cooling power and be used as newly "standard" thermo-electric modules with enhanced characteristics of performance replacing the standard thermo-electric modules in use today.

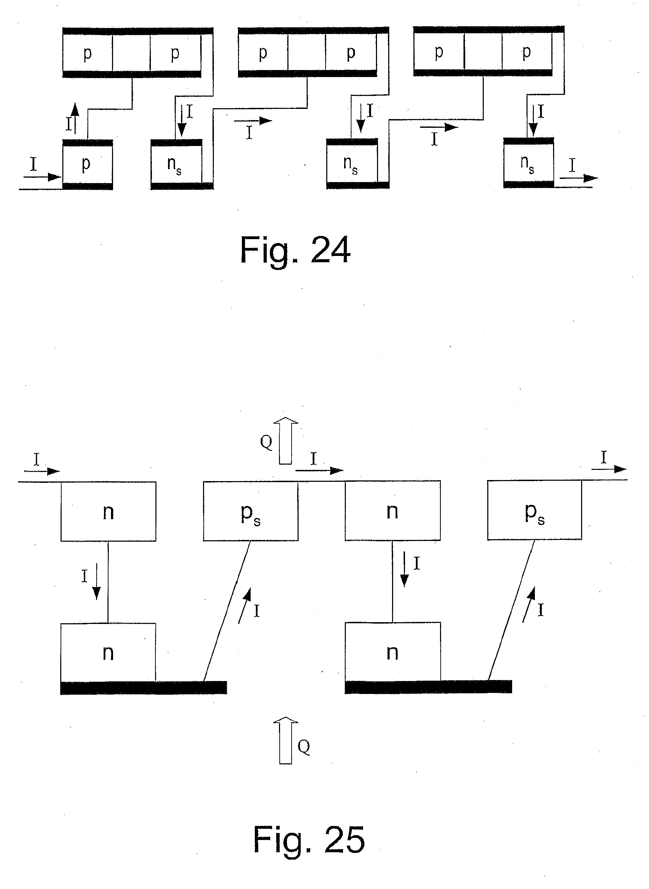

Beyond the split-current schemes shown in Fig. 22A to Fig. 23B. Other schemes may be proposed, once the basic split structure has been adopted. Fig. 24 and Fig. 25 represent two more schemes for routing the current through thermo-electric structures. In the scheme of Fig. 24 the electric current is adjusted to flow with different magnitude through different elements of the thermo-electric structure. In Fig. 25 the current flows with the same value through all elements. In any case, Besides, the split of the current all schemes in fact enable the local absorptions of heat from the thermo-electric junctions which in turn enhances the overall absorptions of the whole thermo-electric setup. Calculations based on modeling as well as experimental testing have pointed out the advantages of each scheme as well as the preferable ranges of operation.

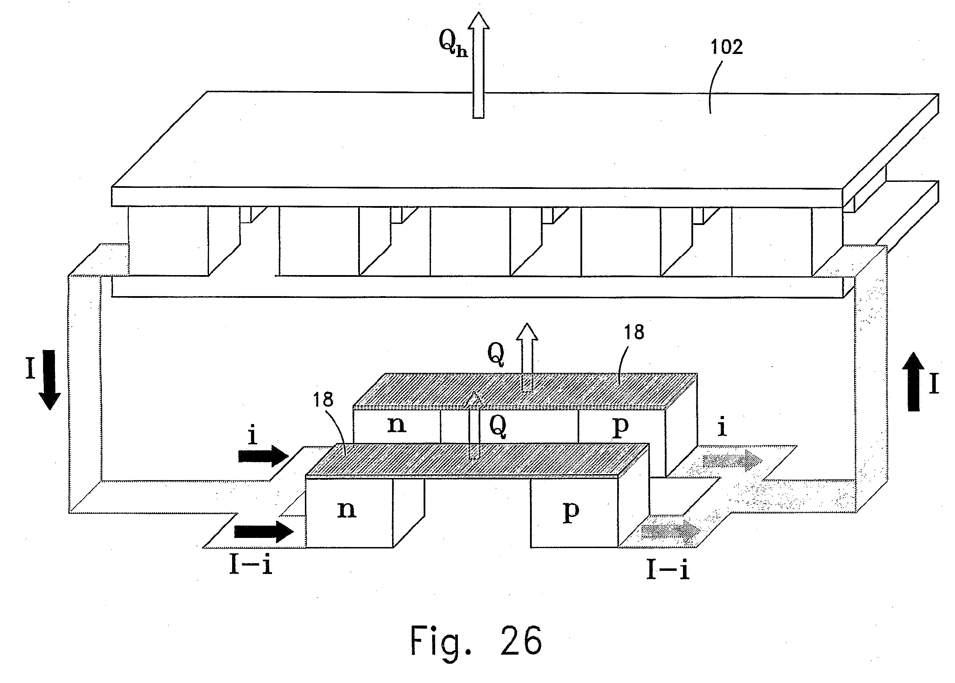

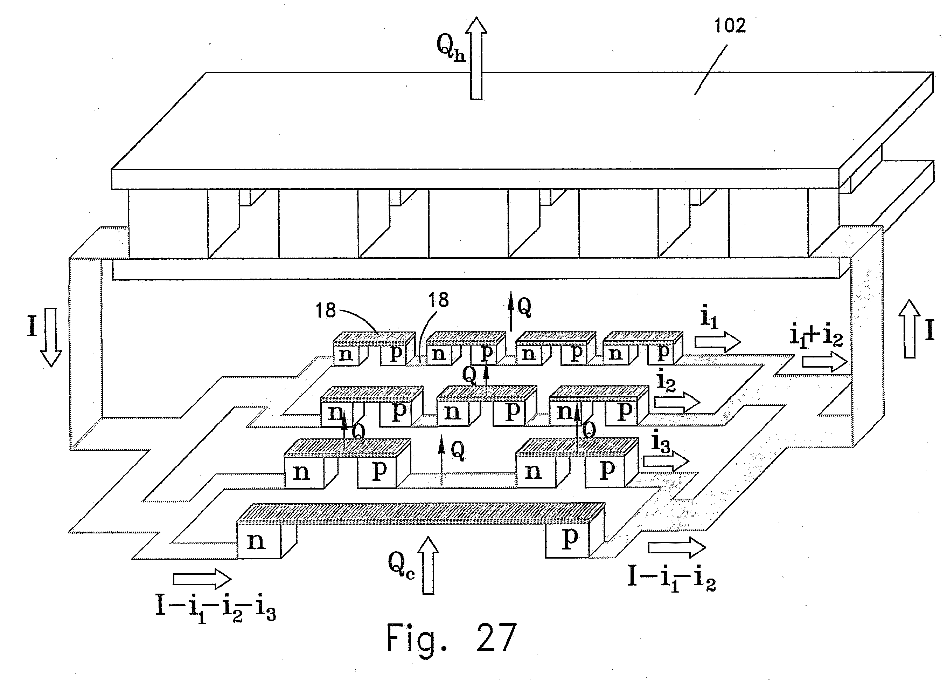

Figures 26 and 27 show schematically thermo-electric units that employ both the thermo-split and the current-split concepts. In Figs. 26 and 26 a sandwich structure 102 as described with respect to Fig. 18 is used at the heat dissipating side and on the heat absorbing side the current is split into two and four distinct values of current that flow through a corresponding number of groups of thermo-electric elements. These structures allow for maximizing the heat absorption and transfer from surfaces having non-uniform thermal conditions, e.g. localized hot or cold spots. Note that in the structures shown in Figs. 26 and 27 it is not necessary to introduce additional absorbers $P_s$ or $N_s$ as in the case of pure current split (Fig. 22A to 23B).

It should be emphasized that the parts of the description herein that relate to cooling systems can all be applied for heating or power generation as well and *vice versa.*

It is to be noted at this point that the over-standardization of existing thermo-electric modules has left the designer, who must use these modules for a variety of physical devices and applications, with a very few degrees of freedom at best or none at all, at worst. This being the case, the designer has to adapt the application around the module instead of adapting the thermo-electric system and phenomena to the requirements of the application under consideration.

At present companies worldwide extensively utilize the standard thermo-electric modules for cooling, heating, or energy generation in various fields of technology such as: electronics, temperature control and temperature stabilization, modern space systems, tele-communications, electronic devices, optical and medical systems, and many other industrial, consumer, scientific and laboratory systems. In all the above areas and many others, the requirements of cooling or efficiently dissipating the heat from electronic components is most crucial to the length of life of the components and hence to the performance of the whole system or device. Such electronic components are usually cooled by standard thermo-electric units attached to a relatively large heat sink and fan system. A typical thermo-electric assembly driven by 2mm thermo-electric module may require a heat sink more than ten times as thick and several times larger in area at each side of the thermo-electric module. A result of this is that the thermo-electric device becomes disproportionately many times larger than the electronic component, requiring more space, which sometimes becomes a crucial parameter in the design. At best this brings about an inefficient design or in the worst case makes the device impossible to cool where the chips are densely arranged or no space is available for cooling systems.

The split structure when applied according to the principles described herein eliminates in fact most of the limitations of existing typical compact modules and of thermo-electric devices based on such modules. For a given application the split concept, use of successive thermo-electric layers, and use of flexible support layers on the hot and cold sides of the structure allow optimization of the overall performance based on the ability to change the parameters of all the elements of the module, as well as the choice of optimal thermo-electric materials in accordance with the specific applications under consideration. In parallel, the concepts of split one-type one-element, one-type element structures, one-leg structures, thermal-split, power-split, and current split introduces many new possibilities for cooling, heating and power generation devices. It is noted that in any application any of the concepts and methods made possible by the split thermo-electric concept can be integrated in the design procedure either separately or in combination.

The present invention in its various embodiments allows the designer to focus on the specific characteristics of a given application, on the one hand, while allowing optimization of the overall performance, based on the ability to treat the parameters of the thermo-electric system, including the best choice of optimal thermo-electric materials at each zone, in accordance with the physical situation of the application under consideration. For example, in equations (12) to (15), the cross-sectional areas of the thermo-electric elements and the intermediate conductor have been assumed to be identical. However it is easy to transform the model used in deriving these equations to the case of different or varying cross-sections of the elements.

As another example, as the characteristics of a one-type split structure have been described, it can be easily stated that splitting the cooling and heating regions contribute to solution of the two critical issues of typical thermo-electric devices, namely; the inability to use the optimal figure of merit, and the reduction of the efficiency due to the heat conduction between the heating and cooling regions. These issues become even more critical when utilizing thin film thermo-electric systems. On the one hand, a dramatic gain in power densities is expected with thin film thermo-electric layers (or multi-layers), while on the other hand, most of the heat flux may flow back from the hot to the cold zone, due to the high temperature gradient across the thin film. Moreover, when moving from bulk to thin film, thermo-electric materials show larger figures of merit, hence it is of high importance to regain the loss of efficiency and even upgrade beyond that obtained with bulk material. Thus recent advances in thermo-electric coolers or generators due to new thermo-electric materials as well as the development of thin film thermo-electric systems may depend on future developments in the appropriate technology. Adopting the one-type split structure may open new ways to take advantage of the superiority of new thermo-electric materials and thin film units. In parallel the split structure allows both flexible design and heat management with more physical degrees of freedom.

The inventors believe that the specific technical details, e.g. the method of soldering or clamping the pellets to the intermediate connections, the method of attaching the pellets to the flexible support layers, the composition of the intermediate connectors, and the composition of the p,n pellets and their dimensions are to be chosen individually according to the requirements of the particular system under consideration. With this in mind, a wide spectrum of applications can be approached in terms of split structure and temperature-successive thermo-electric materials.

A solar thermo-electric panel, such as discussed in connection with Fig. 8, can be made from simple one-type split structures such as shown in Fig. 11B and/or from temperature successive thermo-electric layers as shown in Fig. 6 making use of the design approach based on the coupling between the figures of merit of the thermo-electric materials with the distribution of temperature in the temperature field and the matching of the consistency factors. The same concepts and methods can be applied whenever a temperature gradient is available such as in deep water or geo-thermal cases. In some cases, only the successive layers method can be utilized and in others both the split structure with successive layers can be combined to yield the best performance.

Another way of controlling the output of a one-type split thermo-electric structure is to use the current-split concept to supply different values of current to the hot and cold thermo-electric elements of the leg. For cooling, more efficient heat transfer through the structure can be achieved by triggering the loaded (hot) element with a higher current, while the cold element is triggered by a lower electric current. This can be carried out by draining part of the electric current between the elements, namely splitting the electric current, i.e. using the current-split concept illustrated in Fig. 22A to Fig. 25. This is another illustration of a way in which the split structure allows control, management, and optimization of the performance of the whole thermo-electric system by dealing with each of the hot or cold elements with almost independently according to the requirements of the physical situation.

The rising demand for utilization of renewable energy sources and in parallel the growing awareness of environmental aspects have encouraged a variety of innovative approaches from many areas of science and technology. Advancement directed towards a new generation of thermo-electric structures or systems is one of the challenges in the development of energy alternatives which can have a significant economic and environmental impact. The present invention as described herein above, is not intended or anticipated to be related in any way only to the particular applications or systems described herein, but in fact the principles of the invention can be applied to any thermo-electric application or system for cooling, heating or for power generation.

Another most interesting direction of application of the present invention is in developing electro-energy for use in relatively small self-contained electric energy systems. Interest in this type of system is increasing as part of the worldwide search for alternative (renewable) energy sources. Achievements and developments in the field of thermo-electric technology and thermo-electric modules may become a vital and valid choice for such applications. A few examples of these applications are: small scale stand-alone power and cooling systems; air-conditioning or water coolers on ships, in vehicles, railway carriages, etc.

Another category of essential applications is the use of thermo-electric systems in a variety of portable electric generators capable of producing a few hundred watts of electricity for use by, for example, army units in the field; units for power generation for light, air-conditioning or general electricity supply for remote areas where an electricity infrastructure does not exist, and thermo-electric battery chargers. In all of the above examples and others, the heat source may be directly from solar radiation or from a working thermal fluid such as oil heated by solar energy, hydro-carbon fuel, or exhaust gases from motors. In parallel the heat sink can be the ambient environment, the wind, or a locally available coolant such as a river or body of water. The thermo-electric units used in these applications will be based on assembling as many of the basic units shown in Fig. 14 or Fig. 15 as are necessary to provide the necessary cooling or electric power.

Last but not least, large scale application challenges are not being met using the currently available thermo-electric technology. Whereas the standard thermo-electric modules can only be used with small, sometimes miniature systems; the structure described herein opens a large range of technology for meeting the challenges and the needs of large scale systems. For example, energy lost from extremely hot engines or exhaust pipes in vehicles can be utilized if the heat absorber is attached directly to the engine block or exhaust and the heat sink is located at the front of the moving vehicle where heat sinking (heat dissipation) is by forced convection and hence can be capable of absorbing a large heat flux without exhibiting any increase in temperature. In this and similar systems the heat sink is an integral part of the thermo-electric system and may determine the total system performance. Stated differently, a thermo-electric structure comprised of arrangements of split structures as described herein can be used to turn waste heat from moving vehicles or hot gases released from power stations, etc. and the existing radiator or ambient temperature into an efficient thermo-electric energy recovery device.

All the above are only examples of applications which would benefit by adopting the split structure and/or the concepts and methods described herein. The present invention, when applied to current applications would reduce the complexity, simplify the design and upgrade the overall performance of devices and systems for cooling, heating or power generation.

Although the invention has been described by way of illustration, the specific examples of embodiments and uses of the invention have been provided for the purpose of illustration only. The scope of the invention is not intended by the inventor to be limited in any way by the drawings, arrangements, materials or parameters described. It will be understood that the invention may be carried out with many variations, modifications, and adaptations, without exceeding the scope of the claims. In particular, it is anticipated that new developments in the field of material science, which may result in advanced new, thermo-electric materials for high temperature gradients, etc. can be adopted and assimilated accordingly in the general concepts of the thermo-electric structures of the invention as presented herein.

**Claims**

1. A thermo-electric structure for cooling, heating, or stabilizing the temperature of an object or for electric power generation, said thermo-electric structure comprised of:

   a) at least one n-type leg and at least one p-type leg, wherein each of said legs is comprised of a semiconductor element on the heat absorbing side of said thermo-electric structure, a semiconductor element of the same type on the heat dispersing side of said thermo-electric structure, and an intermediate connector that thermally and electrically connects said two semiconductor elements; and
   b) at least one additional n-type semiconductor element; and
   c) at least one additional p-type semiconductor element;
   said thermo-electric structure **characterized in that** said additional semiconductor elements act as point absorbers of heat from interior thermo-electric junctions and cause different values of electric current to flow through different parts of said structure.

2. The thermo-electric structure of claim 1, wherein the semiconductor elements are comprised of single pellets of thermo-electric material.

3. The thermo-electric structure of claim 1, wherein the semiconductor elements are comprised of a complex multilevel structure consisting of two or more pellets of thermo-electric material and an intermediate connector between each pair of successive pellets of thermo-electric material.

Fig. 1A
Prior Art

Fig. 1B
Prior Art

Fig. 1C
Prior Art

Fig. 1D
Prior Art

16'P    18    16'N    28'

Fig. 2A

Fig. 2B

Fig. 2C

Fig. 3A

Fig. 3B

Fig. 3C

Fig. 3D

EP 2 375 190 A1

Fig. 4A

Fig. 4B

Fig. 4C

Fig. 4D

Fig. 4E

Fig. 5

Fig. 6

Fig. 7

Fig. 8

Fig. 9

Fig. 10A

Fig. 10B

Fig. 10C

Fig. 11A

Fig. 11B

Fig. 12

Fig. 13

Fig. 14

43

Fig. 15

Fig. 16A
Prior Art

Fig. 16B
Prior Art

## Fig. 17A

## Fig. 17B

Fig. 18

Fig. 19

Fig. 20

Fig. 21A

Fig. 21B

Fig. 22A

Fig. 22B

Fig. 23A

Fig. 23B

EP 2 375 190 A1

## Fig. 24

## Fig. 25

EP 2 375 190 A1

Fig. 26

Fig. 27

Europäisches
Patentamt

European
Patent Office

Office européen
des brevets

**EUROPEAN SEARCH REPORT**

Application Number

EP 11 17 2236

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 385 022 A (KORNBLIT LEVY [IL]) 31 January 1995 (1995-01-31) * figure 1 * * column 7, line 45 - line 51 * * column 7, line 52 - column 8, line 8 * ----- | 1-3 | INV. F25B21/04 H01L35/32 |
| | | | TECHNICAL FIELDS SEARCHED (IPC) |
| | | | F25B H01L |

The present search report has been drawn up for all claims

| Place of search | Date of completion of the search | Examiner |
|---|---|---|
| The Hague | 11 August 2011 | Dezso, Gabor |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

......................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 11 17 2236

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2011

| Patent document cited in search report | | Publication date | Patent family member(s) | | Publication date |
|---|---|---|---|---|---|
| US 5385022 | A | 31-01-1995 | AU | 7724794 A | 27-03-1995 |
| | | | WO | 9507441 A1 | 16-03-1995 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IL 2009000666 W